# EUROPEAN PATENT APPLICATION

(11) **EP 4 580 168 A1**
(43) Date of publication of application: **02.07.2025**
(21) Application number: 23877572.0
(22) Date of filing: 27.09.2023
(51) Int. Cl.: H04M 1/02, H05K 1/11, H02K 7/116

(54) **ELECTRONIC DEVICE INCLUDING DRIVING MOTOR**

(30) Priority: 12.10.2022 KR 20220130549; 02.12.2022 KR 20220166823
(71) Applicant: Samsung Electronics Co., Ltd., Suwon-si, Gyeonggi-do 16677 (KR)
(72) Inventor: KANG, Jooyoung, Suwon-si, Gyeonggi-do 16677 (KR); AHN, Jaeuk, Suwon-si, Gyeonggi-do 16677 (KR); SEO, Soohyun, Suwon-si, Gyeonggi-do 16677 (KR); SHIN, Moonchul, Suwon-si, Gyeonggi-do 16677 (KR); CHO, Joongyeon, Suwon-si, Gyeonggi-do 16677 (KR); CHOI, Nakhyun, Suwon-si, Gyeonggi-do 16677 (KR); KIM, Sukdong, Suwon-si, Gyeonggi-do 16677 (KR); HONG, Hyunju, Suwon-si, Gyeonggi-do 16677 (KR)
(74) Representative: Appleyard Lees IP LLP
(86) International application number: PCT/KR2023/014979
(87) International publication number: WO 2024/080644

(57) **Abstract**

According to various embodiments, an electronic device may comprise: a first housing; a second housing slidably coupled to the first housing; a flexible display having a display area that is variable on the basis of the slide-in or slide-out of the second housing; a driving motor disposed in the second housing and including a pinion gear; a rack fixedly coupled to the first housing and including a rack gear driven by being gear-coupled to the pinion gear; and a rack guide disposed in the second housing and protecting the rack from external impact, wherein the rack guide may be disposed on the left side of the driving motor and spatially overlap with a camera module, and while the pinion gear and the rack gear are being driven by being gear-coupled to each other, the second housing may be configured to be driven to slide-in or slide-out on the basis of the reciprocating movement of the rack into the rack guide.

## Description

### [Technical Field]

Various embodiments of the present disclosure relate to an electronic device including a driving motor.

### [Background Art]

Electronic devices are gradually becoming slimmer, more rigid, more design-oriented, and more differentiated in terms of their functional elements. Electronic devices are gradually changing from a uniform rectangular shape to various shapes. Electronic devices may have a deformable structure that is convenient to carry and may utilize a large-screen display. Electronic devices may have a structure (e.g., the rollable structure or a slidable structure) that can vary the display area of a flexible display (e.g., the rollable display) by supporting housings that slide relative to each other. Such electronic devices may require an efficient disposition structure of a driving module that allows the rest of the housing to slide automatically relative to one housing.

### [Disclosure of Invention]

### [Technical Problem]

An electronic device may include a rollable electronic device (e.g., the slidable electronic device) in which a display area of a flexible display (e.g., the rollable display) may be expanded and/or contracted depending on the operating state. The rollable electronic device may include a first housing and a second housing that are movably coupled with respect to one another in a manner that is at least partially fitted together. For example, the first housing and the second housing may be slidably operated with respect to one another and support at least a portion of a flexible display (e.g., the rollable display, an expandable display, or a stretchable display), such that the flexible display is induced to have a first display area in a slide-in state, and to have a second display area larger than the first display area in a slide-out state.

The electronic device may include a driving motor including a pinion gear that automatically operates a second housing to slide a designated reciprocating distance on the basis of a first housing that is disposed in an inner space and is gripped by a user as a driving module, and a rack including a rack gear that is gear-coupled to the pinion gear. For example, when the driving motor is disposed in the first housing or the second housing, a rack that has a length along the sliding direction and is gear-coupled to the pinion gear may be disposed in the remaining housing.

However, since the rack must have a length at least corresponding to the sliding distance of the electronic device, there may be a problem that the surrounding electrical components must be designed to avoid the rack installation space and/or the rack accommodation space. In addition, if the battery among the electrical components is designed to avoid the rack installation space or the accommodation space, its size may be reduced, and the usage time of the electronic device may be reduced because of the reduced battery capacity.

Various embodiments of the present disclosure may provide an electronic device including a drive motor that can help make the electronic device slimmer through an efficient disposition structure between a drive module (e.g., a rack) and peripheral electrical components.

Various embodiments may provide an electronic device including a drive motor having a disposition structure for securing battery capacity.

However, the problem to be solved in the present disclosure is not limited to the problem mentioned above, and may be expanded in various ways without departing from the spirit and scope of the present disclosure.

### [Solution to Problem]

According to various embodiments, an electronic device may comprise: a first housing; a second housing slidably coupled to the first housing; a flexible display having a display area that is variable on the basis of the slide-in or slide-out of the second housing; a driving motor disposed in the second housing and including a pinion gear; a rack fixedly coupled to the first housing and including a rack gear driven by being gear-coupled to the pinion gear; and a rack guide disposed in the second housing and protecting the rack from external impact, wherein the rack guide may be disposed on the left side of the driving motor and spatially overlap with a camera module, and while the pinion gear and the rack gear are being driven by being gear-coupled to each other, the second housing may be configured to be driven to slide-in or slide-out on the basis of the reciprocating movement of the rack into the rack guide.

According to various embodiments, an electronic device may comprise: a first housing; a second housing slidably coupled to the first housing; a flexible display having a display area that is variable on the basis of the slide-in or slide-out of the second housing; a driving motor disposed in the second housing and including a pinion gear; a rack fixedly coupled to the first housing and including a rack gear driven by being gear-coupled to the pinion gear; and a battery disposed in parallel with the rack, wherein, when viewing the side surface of the first housing from the outside in a direction perpendicular to the sliding direction, the rack and the battery may be disposed so as not to overlap each other.

### [Advantageous Effects of Invention]

An electronic device according to exemplary embodiments of the present disclosure may help slim down the electronic device through an efficient disposition structure of electrical components overlapping with the rack. In addition, the electronic device may help secure the capacity of the battery to the maximum by having a disposition structure in which a drive motor including a rack and a pinion gear coupled thereto is disposed so as not to overlap with a battery, thereby helping improve the operating time of the electronic device.

In addition, various effects may be provided that are directly or indirectly identified through this document.

The effects obtainable from the present disclosure are not limited to the effects mentioned above, and other effects not mentioned will be clearly understood by a person skilled in the art to which the present disclosure belongs from the description below.

### [Brief Description of Drawings]

In connection with the description of the drawings, the same or similar reference numerals may be used for identical or similar components.
FIG. 1 is a block diagram of an electronic device within a network environment according to various embodiments of the present disclosure.
FIGS. 2a and 2b are diagrams illustrating front and rear views of an electronic device in a slide-in state according to various embodiments of the present disclosure.
FIGS. 3a and 3b are diagrams illustrating front and rear views of an electronic device in a slide-out state according to various embodiments of the present disclosure.
FIG. 4a is an exploded perspective view of an electronic device according to various embodiments of the present disclosure.
FIG. 4b is a perspective view of a support bracket on which a battery mounted according to various embodiments of the present disclosure.
FIG. 5a is a cross-sectional view of an electronic device as viewed along line 5a-5a of FIG. 2a according to various embodiments of the present disclosure.
FIG. 5b is a cross-sectional view of an electronic device as viewed along line 5b-5b of FIG. 3a according to various embodiments of the present disclosure.
FIG. 6a is a schematic diagram of an electronic device illustrating the disposition structure of a driving motor and a rack in a slide-in state according to various embodiments of the present disclosure.
FIG. 6b is a perspective view of a portion of an electronic device illustrating a disposition configuration of a rack accommodated in a second housing in a slide-in state according to various embodiments of the present disclosure.
FIG. 6c is a cross-sectional view of an electronic device as viewed along line 6c-6c of FIG. 6a according to various embodiments of the present disclosure.
FIG. 7a is a block diagram of an electronic device illustrating the disposition structure of a driving motor and a rack in a slide-out state according to various embodiments of the present disclosure.
FIG. 7b is a perspective view of a portion of an electronic device illustrating a disposition configuration of a rack accommodated in a second housing in a slide-out state according to various embodiments of the present disclosure.
FIG. 8a is a schematic diagram of a portion of an electronic device including electrical components according to various embodiments of the present disclosure.
FIG. 8b is a perspective view of a portion of an electronic device including electrical components according to various embodiments of the present disclosure.
FIG. 8c is a cross-sectional view of a portion of an electronic device taken along line 8c-8c of FIG. 8a according to various embodiments of the present disclosure.
FIG. 8d is a cross-sectional view of a portion of an electronic device taken along line 8d-8d of FIG. 8b according to various embodiments of the present disclosure.
FIG. 9a is a cross-sectional view of an electronic device taken along line 9a-9a of FIG. 8a according to various embodiments of the present disclosure.
FIG. 9b is a perspective view illustrating a disposition structure of a substrate assembly and a connector port according to various embodiments of the present disclosure.
FIG. 10a is a block diagram of a portion of an electronic device according to various embodiments of the present disclosure.
FIG. 10b is a cross-sectional view of an electronic device taken along line 10b-10b of FIG. 10a according to various embodiments of the present disclosure.
FIG. 10c is a cross-sectional view illustrating a slide-out state of the electronic device of FIG. 10a according to various embodiments of the present disclosure.
FIG. 11 is a block diagram of an electronic device illustrating the disposition structure of an antenna member and a first substrate according to various embodiments of the present disclosure.

### [Mode for the Invention]

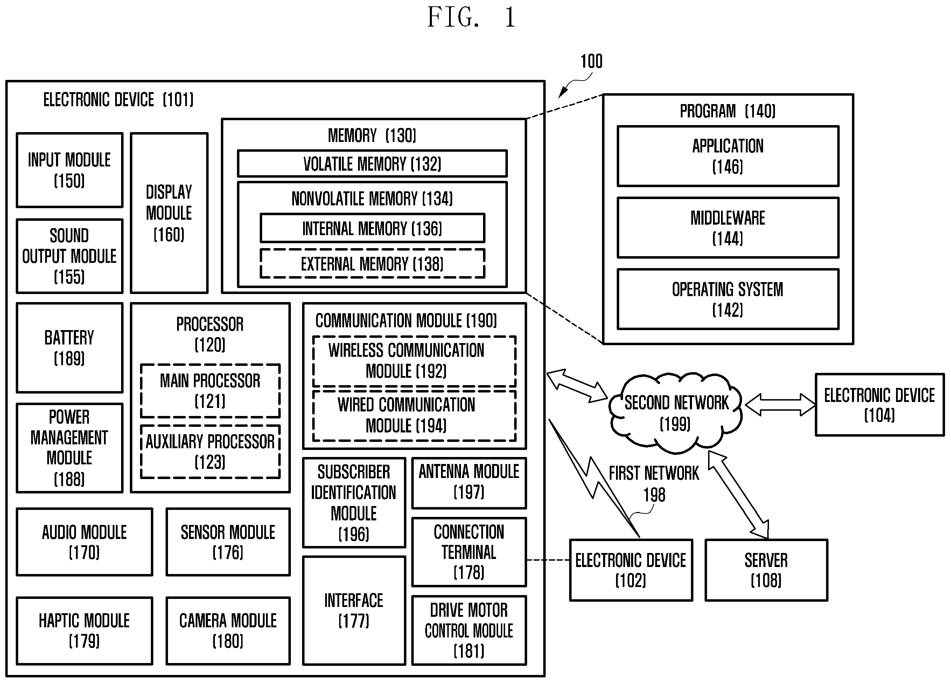

FIG. 1 is a block diagram illustrating an electronic device 101 in a network environment 100 according to various embodiments.

With reference to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, For example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, For example, a microphone, a mouse, a keyboard, a key (e.g., a button), or a digital pen (e.g., a stylus pen).

The sound output module 155 may output sound signals to the outside of the electronic device 101. The sound output module 155 may include, For example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the strength of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, For example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, For example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, For example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, For example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, For example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, For example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a lateral) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI).

According to an embodiment, commands or data may be transmitted or received between the electronic device 101 and the external electronic device 104 via the server 108 coupled with the second network 199. Each of the electronic device 102 or 104 may be a device of a same type as, or a different type, from the electronic device 101. According to an embodiment, all or some of operations to be executed at the electronic device 101 may be executed at one or more of the external electronic device 102, 104, or 108. For example, if the electronic device 101 should perform a function or a service automatically, or in response to a request from a user or another device, the electronic device101, instead of, or in addition to, executing the function or the service, may request the one or more external electronic devices to perform at least part of the function or the service. The electronic device 101 may provide the outcome, with or without further processing of the outcome, as at least part of a reply to the request. To that end, a cloud computing, distributed computing, mobile edge computing (MEC), or client-server computing technology may be used, For example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) on the basis of 5G communication technology or IoT-related technology.

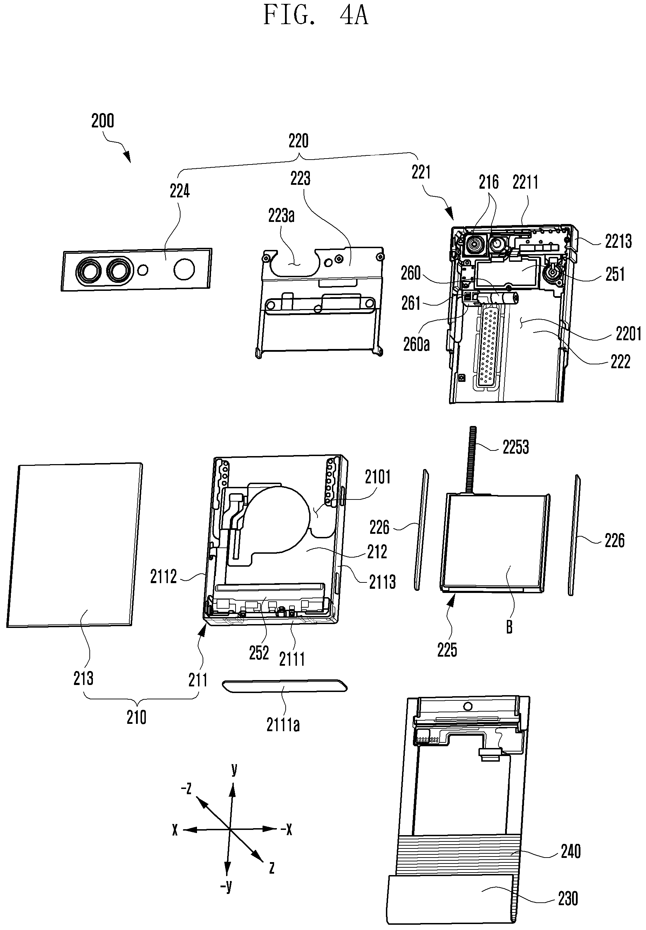

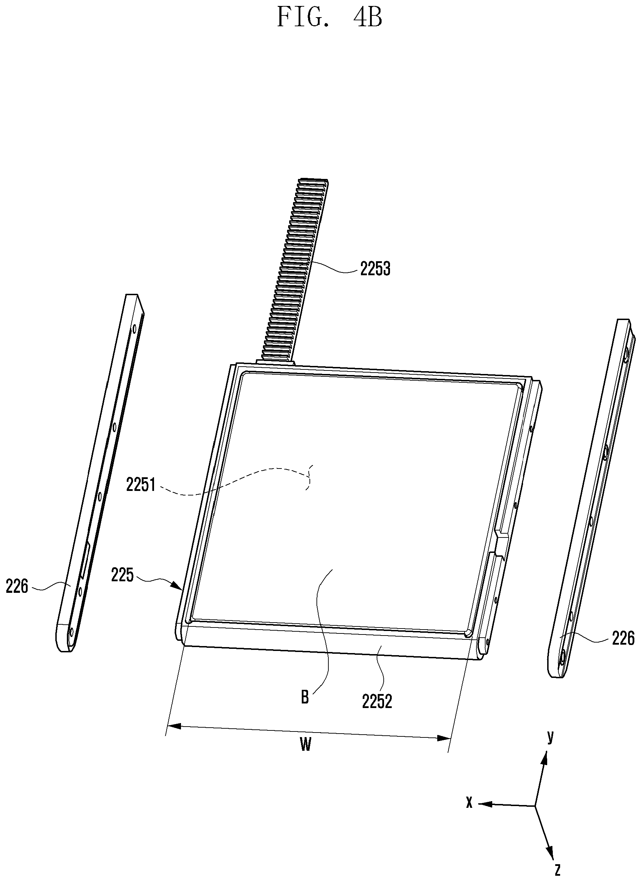

According to various embodiments, the sensor module 176 may include a movement distance detection sensor to detect a movement distance of a second housing (e.g., a second housing 220 in FIG. 4) from a first housing (e.g., a first housing 210 in FIG. 4) of an electronic device (e.g., an electronic device 200 of FIG. 4). In one embodiment, through movement of the second housing 220 from the first housing 210, the sensor module 176 may detect a slide-in state being a first state, a slide-out state being a second state, or an intermediate state being a third state between the slide-in state and the slide-out state. In a certain embodiment, the processor 120 may detect the movement distance in real time through the sensor module 176 while the second housing 220 is moved from the first housing 210, and control the display module 160 to display an object in correspondence to the changing display area through a flexible display (e.g., flexible display 230 in FIG. 4). In one embodiment, the electronic device 101 may include a drive motor control module 181 to control the operation of a drive motor (e.g., DC motor or stepping motor) (e.g., drive motor 260 in FIG. 4) disposed inside the electronic device. In an embodiment, the drive motor control module 181 may be replaced by the processor 120.

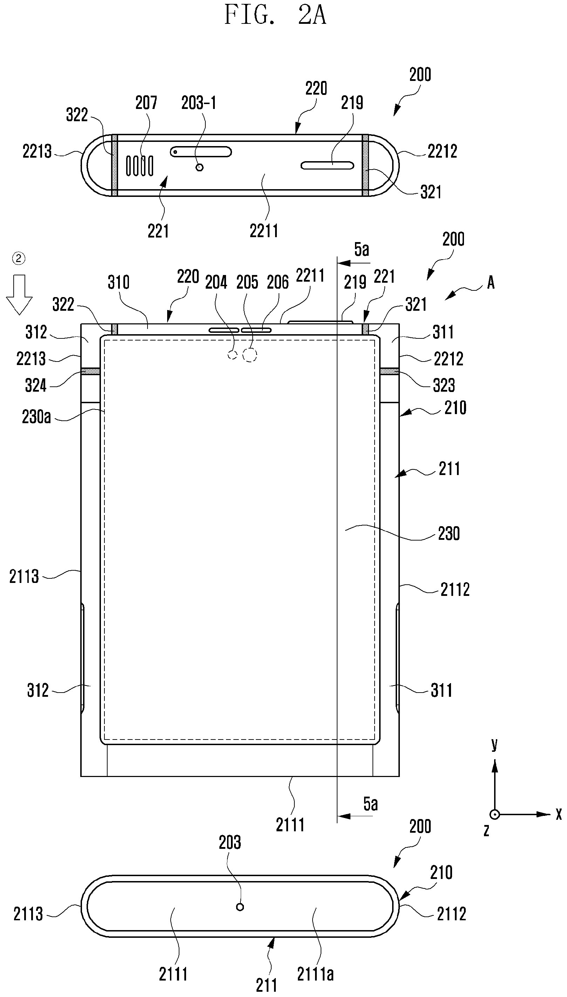

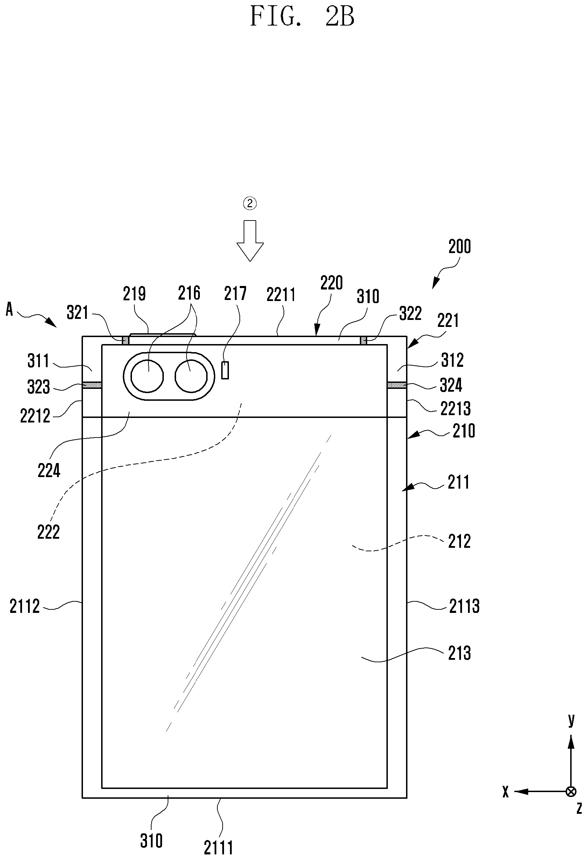

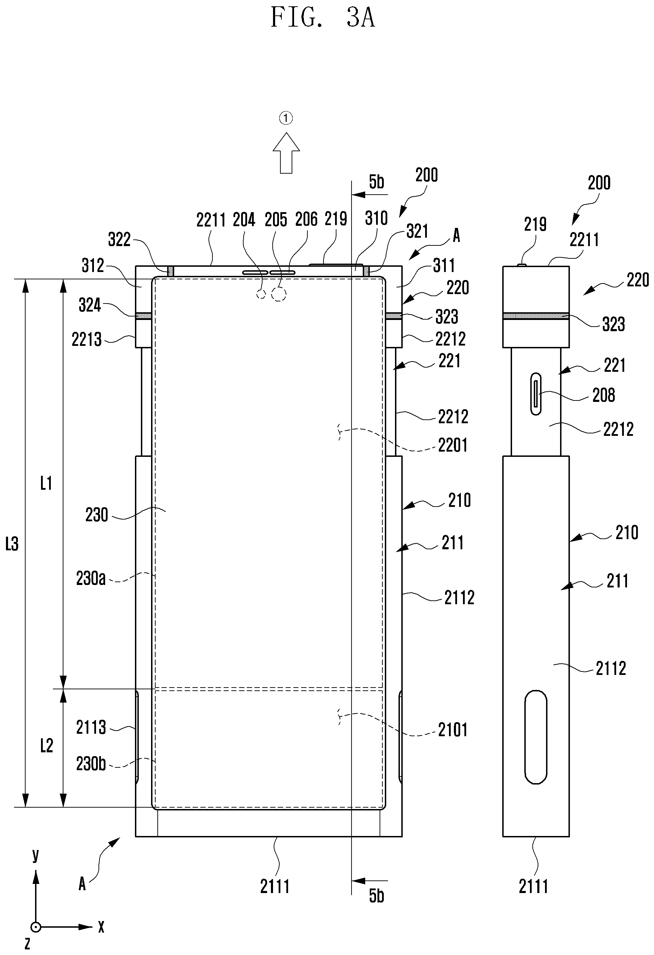

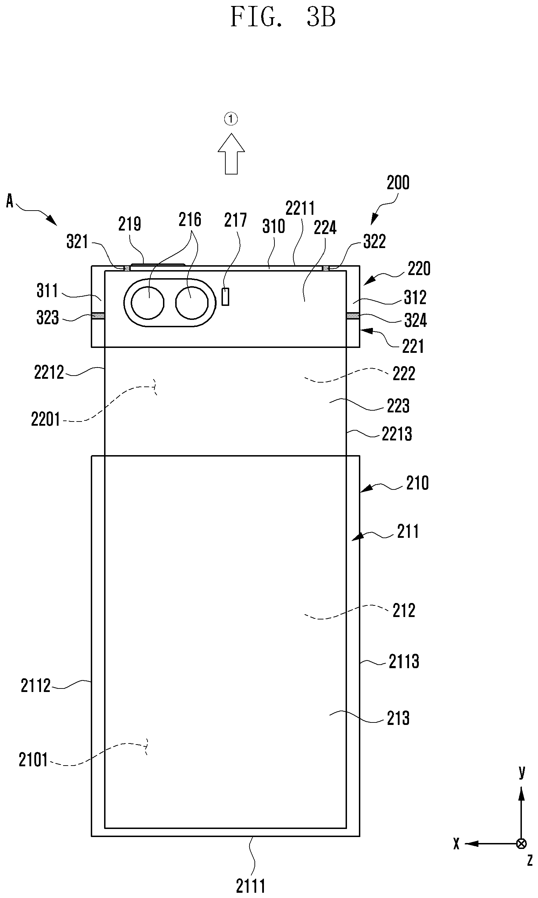

FIGS. 2a and 2b are diagrams illustrating front and rear views of an electronic device in a slide-in state according to various embodiments of the present disclosure. FIGS. 3a and 3b are diagrams illustrating front and rear views of an electronic device in a slide-out state according to various embodiments of the present disclosure.

The electronic device 200 of FIGS. 2a to 3b may be at least partially similar to the electronic device 101 of FIG. 1 or may further include other embodiments of the electronic device.

With reference to FIGS. 2a to 3b, the electronic device 200 may include a first housing 210, a second housing 220 that is slidably coupled to the first housing 210 in a specified direction (e.g., the direction ① or the direction ②) (e.g., the ± y-axis direction), and a flexible display 230 (e.g., the rollable display, the expandable display, or the stretchable display) that is disposed to be supported by at least a portion of the first housing 210 and the second housing 220. In one embodiment, the second housing 220 may be slidably coupled to the first housing 210 so as to be slid out in a first direction (e.g., the direction ①) or slid in a second direction (e.g., the direction ②) that is opposite to the first direction (e.g., the direction ①). In one embodiment, the electronic device 200 may be changed into a slide-in state (e.g., the retracted state) by accommodating at least a portion of the second housing 220 in at least a portion of the first space 2101 formed by the first housing 210. In one embodiment, the electronic device 200 may be changed into a slide-out state (e.g., the extended state) by moving at least a portion of the second housing 220 outwardly (e.g., the direction of ①) from the first space 2101. In one embodiment, the electronic device 200 may include a support member (e.g., the support member 240 of FIG. 4) (e.g., the bendable member, the articulating hinge module, the multi-bar assembly, or the multi-bar) that, in a slide-out state, forms at least partially the same plane as at least a portion of the second housing 220, and, in a slide-in state, is accommodated at least partially into the first space 2101 of the first housing 210 in a bendable manner. In one embodiment, at least a portion of the flexible display 230 may be disposed to be supported by at least a portion of the second housing 220. In one embodiment, at least a portion of the remaining portion of the flexible display 230 may be disposed to be supported by the support member 240 (e.g., the support member 240 of FIG. 4). In one embodiment, the support member 240 may be disposed in a manner that it is attached to the rear surface of the display 230. In one embodiment, at least a portion of the flexible display 230 may be accommodated in a bendable manner into the first space 2101 of the first housing 210 while being supported by the support member (e.g., the support member 240 of FIG. 4) in a slide-in state so that it is not visible from the outside. In one embodiment, at least a portion of the flexible display 230 may be moved so that it is visible from the outside while being supported by the support member (e.g., the support member 240 of FIG. 4) that forms at least partially the same plane as the second housing 220 in a slide-out state.

According to various embodiments, the electronic device 200 may include a first housing 210 including a first lateral member 211 and a second housing 220 including a second lateral member 221. In one embodiment, the first lateral member 211 may be disposed on a lower side of the electronic device 200 and may include a first side surface 2111 having a first length, a second side surface 2112 extending in a vertical direction (e.g., the y-axis direction) from one end of the first side surface 2111 and having a second length, and a third side surface 2113 extending parallel to the second side surface 2112 from the other end of the first side surface 2111 and having a second length. In one embodiment, the first lateral member 211 may be at least partially formed of a conductive material (e.g., metal). In some embodiments, the first lateral member 211 may be formed by combining a conductive member and a non-conductive member (e.g., polymer). In one embodiment, the first housing 210 may include a first extension member 212 that extends from at least a portion of the first lateral member 211 to at least a portion of the first space 2101. In one embodiment, the first extension member 212 may be formed integrally with the first lateral member 211. In some embodiments, the first extension member 212 may be formed separately from the first lateral member 211 and structurally coupled to the first lateral member 211.

According to various embodiments, the second lateral member 221 may be disposed on an upper side of the electronic device 200 and may include a fourth side surface 2211 having a third length, a fifth side surface 2212 extending in a direction perpendicular to the second side surface 2112 from one end of the fourth side surface 2211 (e.g., the - y-axis direction) and having a fourth length, and a sixth side surface 2213 extending in a direction parallel to the fifth side surface 2212 from the other end of the fourth side surface 2211 and having a fourth length and corresponding to the third side surface 2113. In one embodiment, the second lateral member 221 may be formed at least partially of a conductive member (e.g., metal). In some embodiments, the second lateral member 221 may be formed by combining a conductive member and a non-conductive member (e.g., polymer). In one embodiment, at least a portion of the second lateral member 221 may include a second extension member 222 that extends to at least a portion of the second space 2201 of the second housing 220. In one embodiment, the second extension member 222 may be formed integrally with the second lateral member 221. In some embodiments, the second extension member 222 may be formed separately from the second lateral member 221 and structurally coupled to the second lateral member 221.

According to various embodiments, the second side surface 2112 and the fifth side surface 2212 may be slidably coupled with respect to each other. In one embodiment, the third side surface 2113 and the sixth side surface 2213 may be slidably coupled with respect to each other. In one embodiment, in the slide-in state, a portion of the fifth side surface 2212 may be disposed to overlap with the second side surface 2112 so as to be substantially invisible from the outside. In one embodiment, in the slide-in state, a remaining portion of the fifth side surface 2212 may be disposed to be visible from the outside. In some embodiments, in the slide-in state, the fifth side surface 2212 may be disposed to overlap with the second side surface 2112 so as to be substantially invisible from the outside. In one embodiment, in the slide-in state, a portion of the sixth side surface 2213 may be disposed to overlap with the third side surface 2113 so as to be substantially invisible from the outside. In one embodiment, in the slide-in state, the remaining portion of the sixth side surface 2213 may be disposed to be visible from the outside. In some embodiments, in the slide-in state, the sixth side surface 2213 may be disposed to overlap with the third side surface 2113 so as to be substantially invisible from the outside. In one embodiment, a portion of the second extension member 222 may be disposed to be visible from the outside in the slide-in state. In some embodiments, in the slide-in state, the second extension member 222 may be disposed to overlap with the first extension member 212 so as to be substantially invisible from the outside.

According to various embodiments, the first housing 210 may include a first rear cover 213 coupled to at least a portion of the first lateral member 211. In one embodiment, the first rear cover 213 may be disposed in such a way that it is coupled to at least a portion of the first extension member 212. In some embodiments, the first rear cover 213 may be formed integrally with the first lateral member 211. In one embodiment, the first rear cover 213 may be formed of a polymer, a coated or colored glass, a ceramic, a metal (e.g., aluminum, stainless steel (STS), or magnesium), or a combination of at least two of these materials. In some embodiments, the first rear cover 213 may extend to at least a portion of the first lateral member 211. In some embodiments, the first rear cover 213 may be omitted and at least a portion of the first extension member 212 may be replaced with the first rear cover 213.

According to various embodiments, the second housing 220 may include a second rear cover 223 coupled to at least a portion of the second lateral member 221. In one embodiment, the second rear cover 223 may be disposed so as to be coupled to at least a portion of the second extension member 222. In one embodiment, the second rear cover 223 may be formed integrally with the second lateral member 221. In one embodiment, the second rear cover 223 may be formed of a polymer, a coated or colored glass, a ceramic, a metal (e.g., aluminum, stainless steel (STS), or magnesium), or a combination of at least two of these materials. In some embodiments, the second rear cover 223 may extend to at least a portion of the second lateral member 221. In some embodiments, the second rear cover 223 may be omitted, and at least a portion of the second extension member 222 may be replaced with the second rear cover 223. In some embodiments, the second extension member 222 may be omitted, and the second rear cover 223 may be replaced with the second extension member 222. In one embodiment, the second housing 220 may include a window cover 224 disposed on at least a portion of the second rear cover. In one embodiment, the window cover 224 may be disposed in an area exposed to the outside of the second housing 220 in a slide-in state, and may be formed of a material that facilitates detection of an external environment through at least one camera module 216 and/or sensor module 217 disposed in an inner space 2201 of the second housing 220. For example, the window cover 224 may be formed of glass and/or polymer material in which at least an area corresponding to the camera module 216 and/or sensor module 217 is formed transparently.

According to various embodiments, the flexible display 230 may include a first portion 230a (e.g., the flat portion) that is always visible from the outside, and a second portion 230b (e.g., the bendable portion or a bending portion) that extends from the first portion 230a and is accommodated in a manner that is at least partially bent into the first space 2101 of the first housing 210 so as not to be visible from the outside in a slide-in state. In one embodiment, at least a portion of the first portion 230a may be disposed to be supported by the second housing 220, and at least a portion of the first portion 230a and the second portion 230b may be disposed to be at least partially supported by a support member (e.g., the support member 240 of FIG. 4). In one embodiment, the second part 230b of the flexible display 230 may be disposed to form substantially the same plane as the first portion 230a while being supported by a support member (e.g., the support member 240 of FIG. 4) when the second housing 220 is slid out along the first direction (direction ①) and may be visible from the outside. In one embodiment, the second portion 230b of the flexible display 230 may be accommodated in a manner of bending into the first space 2101 of the first housing 210 when the second housing 220 is slid in along the second direction (direction ②) and may be disposed so as not to be visible from the outside. Accordingly, the flexible display 230 may have a variable display area as the second housing 220 slides along a specified direction (e.g., ±y-axis direction) from the first housing 210.

According to various embodiments, the flexible display 230 may have a variable length in a sliding direction (e.g., direction ① or direction ②) according to the sliding movement of the second housing 220 relative to the first housing 210. For example, the flexible display 230 may have a first display area (e.g., the area corresponding to the first portion 230a) corresponding to a first length L1 in a slide-in state. In one embodiment, the flexible display 230 may be expanded to have a second display area (e.g., the area including the first portion 230a and the second portion 230b) corresponding to a third length L3 longer than the first length L1 and larger than the first display area, according to the movement distance of the second housing 220 moved by the second length L2 relative to the first housing 210 in a slide-out state.

According to various embodiments, the electronic device 200 may include at least one of an input device (e.g., the microphone 203-1), an audio output device (e.g., the call receiver 206 and/or a speaker 207), a sensor module 204 and 217, a camera module (e.g., the first camera module 205 or the second camera module 216), a connector port 208, a key input device 219, or an indicator (not shown) disposed in the second space 2201 of the second housing 220. In one embodiment, the electronic device 200 may include another input device (e.g., the microphone 203) disposed in the first housing 210. In some embodiments, the electronic device 200 may be configured such that at least one of the above-described components is omitted, or other components are additionally included. In some embodiments, at least one of the components described above may be disposed in the first space 2101 of the first housing 210.

According to various embodiments, the input device may include a microphone 203-1. In some embodiments, the input device (e.g., the microphone 203-1) may include a plurality of microphones disposed to detect the direction of sound. The audio output device may include, for example, a call receiver 206 and a speaker 207. In one embodiment, the speaker 207 may be in contact with the outside through at least one speaker hole formed in the second housing 220 at a position that is always exposed to the outside (e.g., the fourth side surface 2211), regardless of the slide-in/slide-out state. In one embodiment, the connector port 208 may be in contact with the outside through a connector port hole formed in the second housing 220 in the slide-out state. In one embodiment, the connector port 208 may be covered so as not to be visible from the outside in the slide-in state. In some embodiments, the connector port 208 may be formed in the first housing 210 in a slide-in state and may be externally responsive through an opening formed to correspond with the connector port hole. In some embodiments, the call receiver 206 may include a speaker (e.g., the piezo speaker) that is operated without a separate speaker hole.

According to various embodiments, the sensor modules 204 and 217 may generate electrical signals or data values corresponding to an internal operating state of the electronic device 200 or an external environmental state. In one embodiment, the sensor modules 204 and 217 may include, for example, a first sensor module 204 (e.g., the proximity sensor or the ambient light sensor) disposed on the front surface of the electronic device 200 and/or a second sensor module 217 (e.g., the heart rate monitoring (HRM) sensor) disposed on the rear surface of the electronic device 200. In one embodiment, the first sensor module 204 may be disposed on the front surface of the electronic device 200 under the flexible display 230. In one embodiment, the first sensor module 204 and/or the second sensor module 217 may include at least one of a proximity sensor, an ambient light sensor, a time of flight (TOF) sensor, an ultrasonic sensor, a fingerprint recognition sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, or a humidity sensor.

According to various embodiments, the camera module may include a first camera module 205 disposed on the front surface of the electronic device 200 and a second camera module 216 disposed on the rear surface of the electronic device 200. In one embodiment, the electronic device 200 may also include a flash (not shown) disposed near the second camera module 216. In one embodiment, the camera modules 205 and 216 may include one or more lenses, an image sensor, and/or an image signal processor. In one embodiment, the first camera module 205 may be disposed under the flexible display 230 and configured to capture a subject through a portion of an active area (e.g., the display area) of the flexible display 230.

According to various embodiments, among the camera modules, the first camera module 205 and, among the sensor modules 204 and 217, the first sensor module 204 may be disposed to detect an external environment through the flexible display 230. For example, the first camera module 205 or the first sensor module 204 may be disposed in the second space 2201 of the second housing 220 so as to be in contact with the external environment through a transparent area or a perforated opening formed in the flexible display 230. In one embodiment, an area of the flexible display 230 facing the first camera module 205 may be formed as a transparent area having a designated transmittance as part of an active area that displays content. In one embodiment, the transparent area may be formed to have a transmittance in a range of about 5% to about 20%. Such a transparent area may include an area overlapping with an effective area (e.g., the field of view area) of the first camera module 205 through which light passes to be imaged by the image sensor to generate an image. For example, the transparent area of the flexible display 230 may include an area having a lower pixel disposition density and/or lower wiring density than the surrounding area. For example, the transparent area may be replaced with the opening described above. For example, some camera modules 205 may include an under display camera (UDC). In some embodiments, some sensor modules 204 may be disposed to perform their functions without being visually exposed through the flexible display 230 in the second space 2201 of the second housing 220.

According to various embodiments, the slide-in operation and/or the slide-out operation of the electronic device 200 may be performed automatically. For example, the slide-in operation and/or the slide-out operation of the electronic device 200 may be performed through gear engagement between a driving motor (e.g., the driving motor 260 of FIG. 4) including a pinion gear (e.g., the pinion gear 261 of FIG. 4) disposed in a second space 2201 of the second housing 220 and a rack (e.g., the rack 2253 of FIG. 4) disposed in the first space 2101 of the first housing 210, extending to at least a portion of the second space 2201, and including a rack gear coupled to the pinion gear 261. For example, when a processor (e.g., the processor 120 of FIG. 1) of the electronic device 200 detects a triggering signal for transitioning from a slide-in state to a slide-out state or from a slide-out state to a slide-in state, the processor may drive a driving motor (e.g., the driving motor 260 of FIG. 4) disposed inside the electronic device 200. In one embodiment, the triggering signal may include a signal according to selection (e.g., touch) of an object displayed on the flexible display 230 or a signal according to operation (e.g., pressing) of a physical button (e.g., the key button) included in the electronic device 200.

According to various embodiments, the electronic device 200 may have a structure in which the second housing 220 slides in and/or out relative to the first housing 210 along a longitudinal direction (e.g., vertical direction) (e.g., ± y-axis direction) of the electronic device 200, but is not limited thereto. For example, the electronic device 200 may have a structure in which the second housing 220 slides in and/or out relative to the first housing 210 along a width direction (e.g., horizontal direction) (e.g., the ± x-axis direction) perpendicular to the longitudinal direction of the electronic device 200. In some embodiments, the electronic device 200 may be formed such that the length of the first side surface 2111 of the first housing 210 is longer than the length of the second side surface 2112. In this case, the length of the fourth side surface 2211 of the second housing 220 may also be formed to be longer than the length of the fifth side surface 2212.

According to various embodiments, the electronic device 200 may include at least one antenna A disposed through at least a portion of a second lateral member 221 of the second housing 220. In one embodiment, the electronic device 200 may include at least one unit conductive portion 310, 311, and 312 formed through at least one segmentation portion 321, 322, 323, and 324. In one embodiment, the electronic device 200 may include a first conductive portion 310 disposed through a first segmentation portion 321 and a second segmentation portion 322 spaced apart from each other by a specified interval on a fourth side surface 2211 of the second lateral member 221. In one embodiment, the electronic device 200 may include a first segmentation portion 321 and a second conductive portion 311 disposed through a third segmentation portion 323 formed on a fifth side surface 2212. In one embodiment, the electronic device 200 may include a second segmentation portion 322 and a third conductive portion 312 disposed through a fourth segmentation portion 324 formed on a sixth side surface 2213. In one embodiment, at least one conductive portion among the first conductive portion 310, the second conductive portion 311, or the third conductive portion 312 may be electrically connected to a wireless communication circuit of the electronic device 200 (e.g., the wireless communication module 192 of FIG. 1) so as to be used as at least one antenna A operating in at least one designated frequency band (e.g., the legacy band or an NR band). For example, the at least one designated frequency band may cover a range of about 600 MHz to 9000 MHz.

FIG. 4a is an exploded perspective view of an electronic device according to various embodiments of the present disclosure. FIG. 4b is a perspective view of a support bracket on which a battery is mounted according to various embodiments of the present disclosure.

In describing the electronic device 200 of FIG. 4a, components that are substantially the same as those of the electronic devices 200 of FIGS. 2a to 3b are given the same reference numerals, and a detailed description thereof may be omitted.

With reference to FIGS. 4a and 4b, the electronic device 200 may include a first housing 210 including a first space 2101, a second housing 220 that is slidably coupled to the first housing 210 and includes a second space 2201, a support member 240 (e.g., the bendable member or a multi-bar assembly) that is fixed to at least a portion of the second housing 220 and is at least partially bendably accommodated into the first space 2101 according to a slide-in motion, a flexible display 230 that is disposed to receive support from at least a portion of the support member 240 and the second housing 220, and a drive module (e.g., the drive mechanism) that drives the second housing 220 from the first housing 210 in a slide-in direction (e.g., the -y-axis direction) and/or a slide-out direction (e.g., the y-axis direction). In one embodiment, the first housing 210 may include a first lateral member 211 and a first rear cover 213 coupled to at least a portion of the first lateral member 211 (e.g., at least a portion of the first extension member 212). In one embodiment, the first space 2101 may be formed by the coupling of the first lateral member 211 and the first rear cover 213. In one embodiment, the second housing 220 may include a second lateral member 221, a second rear cover 223 coupled to at least a portion of the second lateral member 221 (e.g., at least a portion of the second extension member 222), and a window cover 224 coupled to the second rear cover 223. In one embodiment, the second space 2201 may be formed by combining the second lateral member 221, the second rear cover 223, and the window cover 224. In one embodiment, a portion of the second rear cover 223 may include a notch area 223a formed to expose the second camera module 216 disposed in the second space 2201. In one embodiment, the notch area 223a may be protected from the outside by the window cover 224 disposed thereon. In one embodiment, the first housing 210 may further include a cover member 2111a disposed to cover at least a portion of the first side surface 2111.

According to various embodiments, the drive module may include a driving motor 260 disposed in the second space 2201 and including a pinion gear 261, and a rack 2253 fixed to the support bracket 225 and extending from the first space 2101 to the second space 2201, and including a rack gear disposed to engage the pinion gear 261. In one embodiment, the electronic device 200 may further include a reduction module (e.g., the reduction gear assembly) disposed to engage with the driving motor 260 to reduce the rotational speed and increase the driving force. In one embodiment, the driving motor 260 may be disposed in the second space 2201 of the second housing 220 to be supported by a second extension member 222. In one embodiment, the driving motor 260 may be disposed to be supported by a motor bracket 260a fixed to the second extension member 222. In some embodiments, the motor bracket 260a may further include a guide structure that guides the rack 2253 in a sliding direction. Accordingly, when the electronic device 200 is assembled, the pinion gear 261 may maintain a state of gear engagement with the rack 2253, and the pinion gear 261 provided with the driving force of the driving motor 260 may move along the rack 2253, thereby causing the second housing 220 to move relative to the first housing 210.

According to various embodiments, the electronic device 200 may include a support bracket 225 fixed to the first space 2101 of the first housing 210. In one embodiment, the support bracket 225 may include a battery mounting portion 2251 for accommodating a battery B and a support portion 2252 formed on the lower side of the battery mounting portion 2251 and supporting a rear surface of a support member 240 that is bent during a sliding motion transitioning from a slide-out state to a slide-in state. In one embodiment, the support portion 2252 may have an outer surface formed to be curved for smooth guidance of the support member 240. In one embodiment, the electronic device 200 may include a pair of guide rails 226 that are fixed to both sides of the support bracket 225 to guide both ends of the support member 240 in a sliding direction while simultaneously guiding the second housing 220 in a sliding direction. In one embodiment, the support bracket 225 and the guide rails 226 may be fixed in the inner space 2101 of the first housing 210 through a fastening member, such as a screw.

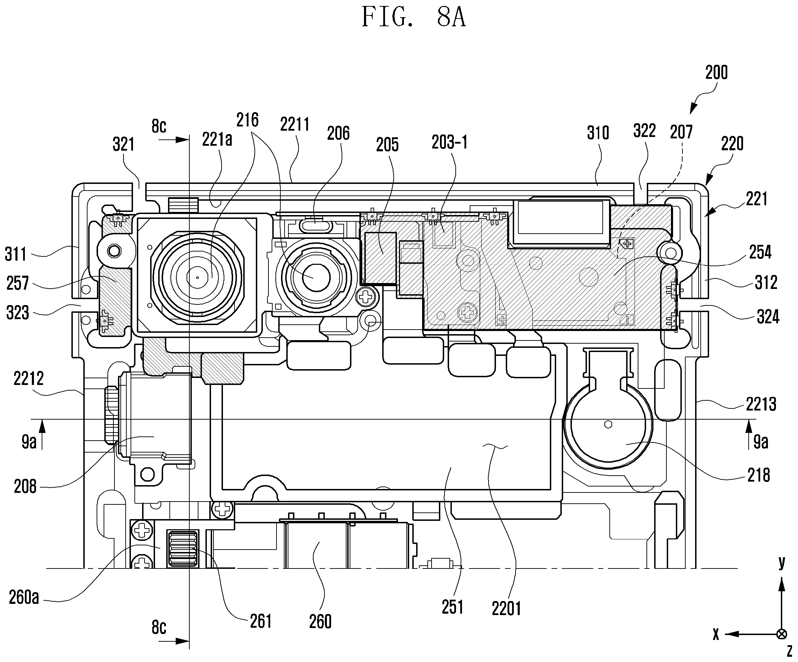

According to various embodiments, the electronic device 200 may include at least one electrical component disposed in the second space 2201. In one embodiment, the at least one electrical component may include a substrate assembly 251 (e.g., the main substrate) (e.g., stacked substrates or a main PCB) and a second camera module 216 disposed around the substrate assembly 251. In one embodiment, the at least one electrical component may include at least one of a microphone (e.g., the microphone 203-1 of FIG. 8a), a first camera module (e.g., the first camera module 205 of FIG. 8a), a receiver (e.g., the receiver 206 of FIG. 8a), a speaker (e.g., the speaker 207 of FIG. 8a), a vibration motor (e.g., the vibration motor 218 of FIG. 8a), or a connector port (e.g., the connector port of FIG. 8a) disposed around the substrate assembly 251. In some embodiments, at least one electrical component may be disposed in the first space 2101 of the first housing 210. In one embodiment, the substrate assembly 251 may be disposed generally centrally in the second space 2201 of the second housing 220, with the at least one electrical component disposed along the periphery thereof, thereby enabling efficient electrical connection between the substrate assembly 251 and the at least one electrical component.

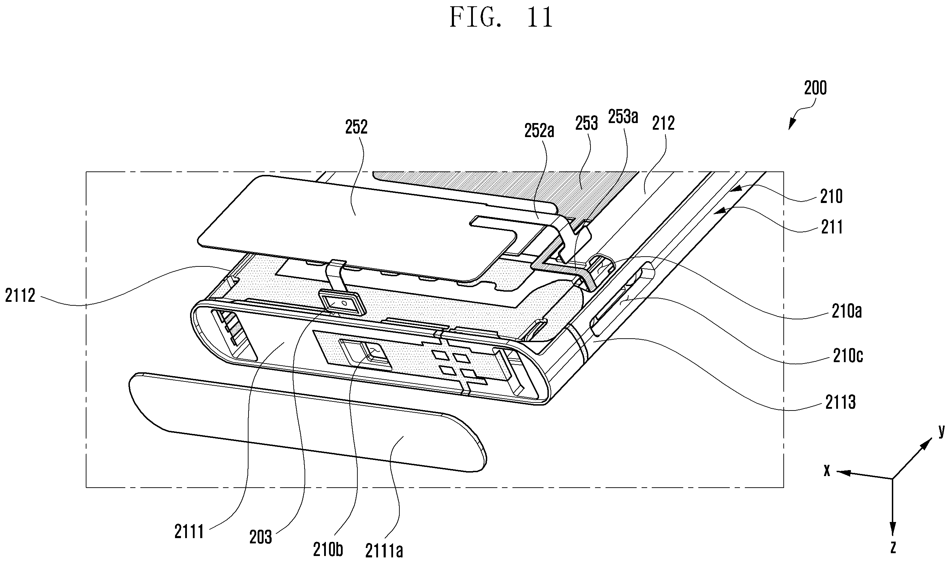

According to various embodiments, the electronic device 200 may include a first substrate 252 (e.g., the first sub-substrate) and an antenna member (e.g., the antenna member 253 of FIG. 13) disposed between a first extension member 212 and a first rear cover 213 in a first housing 210. In one embodiment, the first substrate 252 and the antenna member (e.g., the antenna member 253 of FIG. 13) may be disposed between the first extension member 212 and the first rear cover 213. In one embodiment, the first substrate 252 and the antenna member 253 may be electrically connected to a substrate assembly 251 through a flexible substrate (e.g., the flexible substrate F1 of FIG. 11a) (e.g., the FPCB, flexible printed circuit board or FRC, flexible RF cable). In one embodiment, the antenna member (e.g., the antenna member 253 of FIG. 13) may include a multi-function coil (or multi-function core) antenna for performing a wireless charging function, a near field communication (NFC) function, and/or an electronic payment function. In some embodiments, the antenna member (e.g., the antenna member 253 of FIG. 13) may be electrically connected to a third substrate (e.g., the third substrate 255 of FIG. 11a) disposed around the driving motor 260, thereby being electrically connected to the substrate assembly 251.

According to an exemplary embodiment of the present disclosure, the battery B disposed in the battery mounting portion 2251 of the support bracket 225 may be designed to expand in size as much as possible in the width direction (e.g., the ±x-axis direction) without any separate component disposition other than the guide structure (e.g., the guide structure of the guide rail 226 and the second housing 220) between the support bracket 225 and the second housing 220. For example, the width W of the battery B disposed in the battery mounting portion 2251 may be similar to or the same as the width of the electronic device 200 (e.g., the width of the electronic device in the x-axis direction). Such an expansion in the size of the battery B may help improve the reliability of the electronic device 200 by increasing the usage time of the device. In some embodiments, the battery B may be directly mounted on the battery mounting portion formed through a structural change of the first extension member 212 of the first housing 210 without the support bracket 225. In this case, the rack 2253 may be fixed to at least a portion of the first housing 210, and the size of the battery B may be further expanded in the width direction (e.g., the ±x-axis direction).

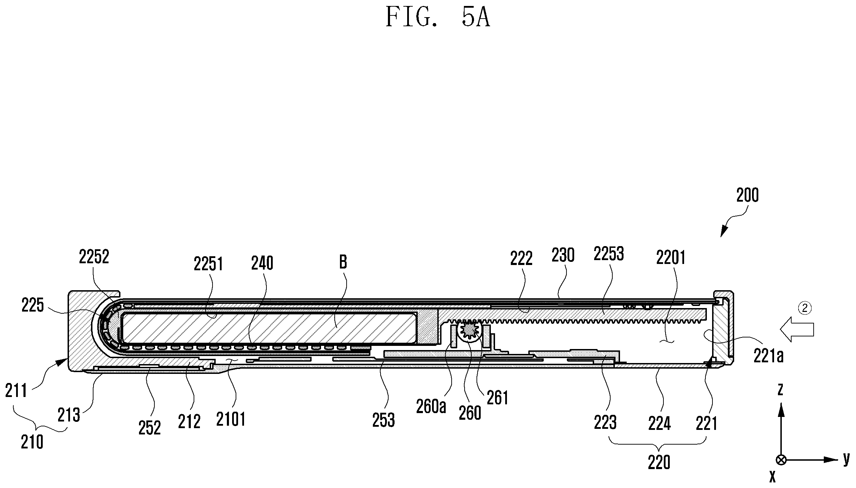

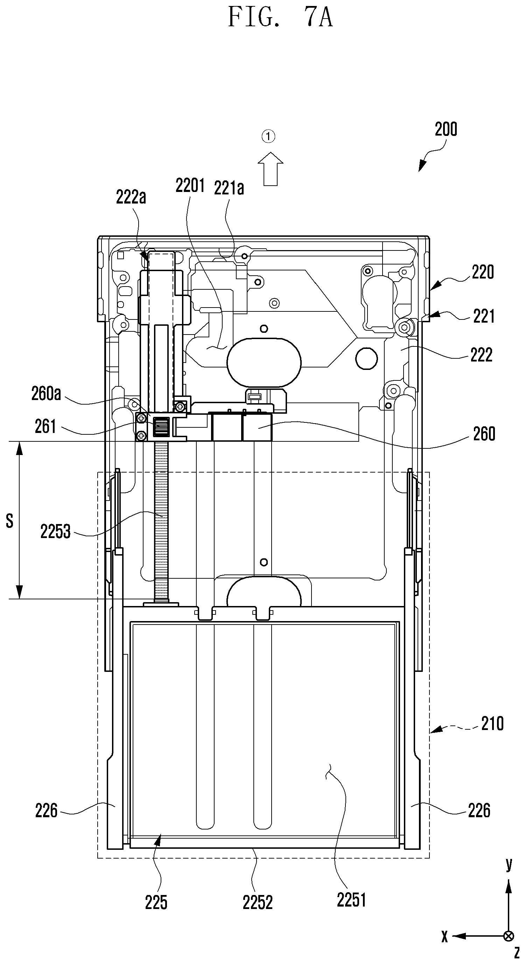

According to an exemplary embodiment of the present disclosure, the electronic device 200 may include a rack 2253 that is fixed to the support bracket 225, has a length in the direction of the second housing 220 (e.g., the y-axis direction), and extends into the second space 2201. In one embodiment, when a side surface (e.g., the second side surface 2112 or the third side surface 2113) of the first housing 210 is viewed from the outside, the rack 2253 and the battery B may be disposed so as not to overlap each other. In one embodiment, when the flexible display 230 is viewed from above, the rack 2153 and the battery B may be disposed so as not to overlap each other. In one embodiment, a sliding distance (e.g., the sliding distance S of FIG. 7a) of the second housing 220 may be determined through the length of the rack 2253. In one embodiment, the rack 2253 may be determined to have a length corresponding to a distance from the support bracket 225 to an upper inner surface (e.g., the inner surface 221a of FIG. 5a) (e.g., the inner surface corresponding to the fourth side surface 2211 of the second housing 220) of the second space 2201 when the electronic device 200 is in a slide-in state. For example, when the distance from the support bracket 225 to the upper inner surface 221a of the second space 2201 becomes shorter in the slide-in state, the length of the rack 2253 may also become shorter, and the sliding distance of the second housing 220 may also become shorter in proportion thereto. In one embodiment, in the slide-in state, when the distance from the support bracket 225 to the upper inner surface 221a of the second space 2201 becomes longer, the length of the rack 2253 may also become longer, and the sliding distance of the second housing 220 may also become longer in proportion thereto. Accordingly, the length of the rack 2253 may be determined by the size of the battery B mounted on the battery mounting portion 2251 of the support bracket 225. This may mean that when the sliding distance of the second housing 220 is determined, the size of the battery B may be designed to be as expandable as possible to correspond to the first space 2201.

According to an exemplary embodiment of the present disclosure, the rack 2253 may be disposed to be generally biased to one side with respect to the width direction (e.g., the x-axis direction) of the electronic device 200. For example, the rack 2253 may be disposed to be biased toward the right side (e.g., the x-axis direction) of the electronic device 230 when the flexible display 230 is viewed from the front. This biased disposition structure of the rack 2253 may efficiently utilize the dead space disposed to overlap with the camera module, and may help secure the size of the substrate assembly 251 (e.g., a main substrate) disposed in the second space 2201.

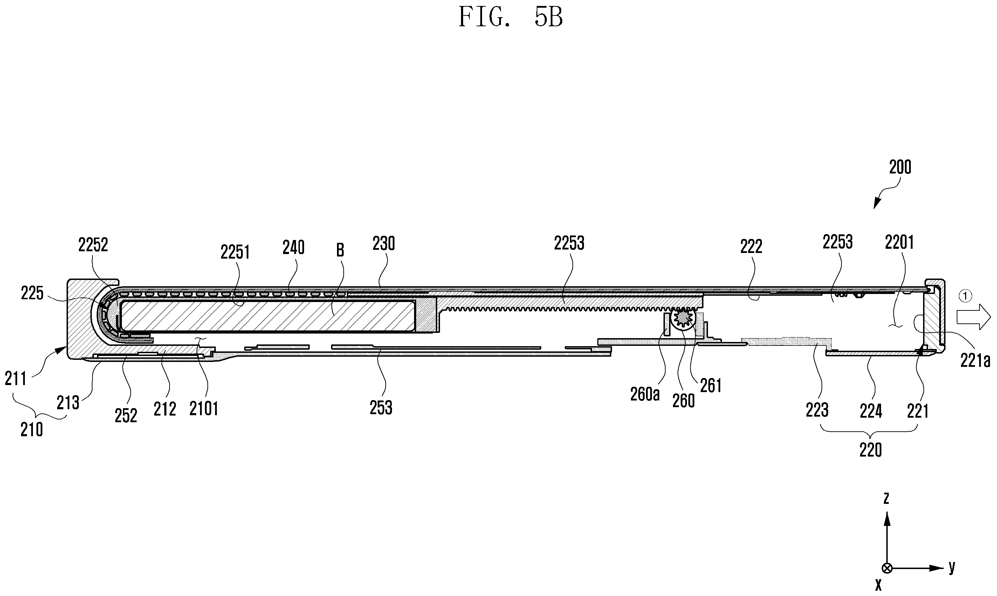

FIG. 5a is a cross-sectional view of an electronic device as viewed along line 5a-5a of FIG. 2a according to various embodiments of the present disclosure. FIG. 5b is a cross-sectional view of an electronic device as viewed along line 5b-5b of FIG. 3a according to various embodiments of the present disclosure.

In describing the electronic device 200 of FIGS. 5a and 5b, components that are substantially the same as those of the electronic device 200 of FIG. 4 are given the same reference numerals, and a detailed description thereof may be omitted.

With reference to FIGS. 5a and 5b, the electronic device 200 may include a first housing 210 having a first space 2101, a second housing 220 having a second space 2201, a support member 240 connected to the second housing 220 and at least partially accommodated into the first space 2101 in a slide-in state, a flexible display 230 disposed to receive support from at least a portion of the support member 240 and at least a portion of the second housing 220, and a driving motor 260 including a pinion gear 261 fixed to the first space 2101 and gear-coupled to a rack 2253 extending into the second space 2201. In one embodiment, the driving motor 260 may automatically move the second housing 220 in a slide-out direction (direction ①) or a slide-in direction (direction ②) on the basis of the first housing 210 through the gear engagement of the pinion gear 261 and the rack 2253. In one embodiment, the electronic device 200 may include a first rear cover 213 coupled to a first extension member 212 extended from a first lateral member 211 of the first housing 210. In one embodiment, the electronic device 200 may include a first substrate 252 and an antenna member 253 disposed in a space between the first extension member 212 and the first rear cover 213. In one embodiment, the electronic device 200 may include a second rear cover 223 coupled to a second extension member 222 extending from a second lateral member 221 and a window cover 224 coupled to a portion of the second rear cover 223.

According to various embodiments, a portion of the second housing 220 may be accommodated in the first space 2101 of the first housing 210 in the slide-in state (state of FIG. 5a) of the electronic device 200. In one embodiment, at least a portion of the flexible display 230 may be accommodated in a manner of being bent into the first space 2101 together with the support member 240, thereby being disposed so as not to be visible from the outside. In this case, the flexible display 230 may have a first display area (e.g., the display area corresponding to the first portion 230a of FIG. 3a) exposed to the outside.

According to various embodiments, at least a portion of the second housing 220 may be transitioned to a slide-out state in which it moves outwardly from the first housing 210 at least partially along the first direction (direction ①) by driving the driving motor 260. In one embodiment, the flexible display 230 may be supported by the support bracket 225 and moved together with the support member 240 in the slide-out state (state of FIG. 5b) of the electronic device 200, such that a portion that has slid in to the first space 2101 may be exposed so as to be at least partially visible from the outside. In this case, the flexible display 230 may be exposed to the outside with a second display area that is expanded more than the first display area (e.g., the display area including the first portion 230a and the second portion 230b of FIG. 3a).

According to various embodiments, the electronic device 200 may include a battery B disposed through a battery mounting portion 2251 of a support bracket 225 fixed to a first space 2101 of a first housing 210. In one embodiment, the battery B may be disposed in the first housing 210 through the support bracket 225, and be expanded in thickness in a manner such that it is proximate to or in contact with a rear surface of a support member 240 from the battery mounting portion 2251 of the support bracket 225, so that the battery volume relatively increases in the -z-axis direction, and the support member 240 that moves in the first space 2101 is supported.

According to an exemplary embodiment of the present disclosure, in the slide-in state, as the second housing 220 moves in the second direction (direction ②), the end of the rack 2253 may be disposed to be in contact with or proximate to the upper inner surface 221a of the second space 2201. In one embodiment, in the slide-out state, as the second housing 220 moves in the first direction (direction ①), the end of the rack 2253 may be disposed to move away from the upper inner surface 221a of the second space 2201, and at least a portion of the rack 2253 may still be disposed to receive support (e.g., guide) from the second housing 220 (e.g., the second extension member 222) in the second space 2201. In one embodiment, the rack 2253 may be formed to have a length corresponding to the distance from the support bracket 225 to the upper inner surface 221a of the second space 2201 in the slide-in state. In one embodiment, the rack 2253 may have an interworking disposition structure that is fixed to the first space 2101 and accommodated (e.g., guided) in the second space 2201 of the second housing 220 according to a sliding motion. This interworking disposition structure prevents the rack 2253 and the battery B from overlapping when the side surface of the first housing 210 (e.g., the second side surface 2112 or the third side surface 2113) is viewed from the outside and when the flexible display 230 is viewed from above, thereby maximizing the size (e.g., battery capacity) of the battery B in the width direction (e.g., the ±x-axis direction) and/or length direction (e.g., ±y-axis direction) of the first housing 210, thereby helping increase the usage time of the electronic device 200 and improve the reliability of the device.

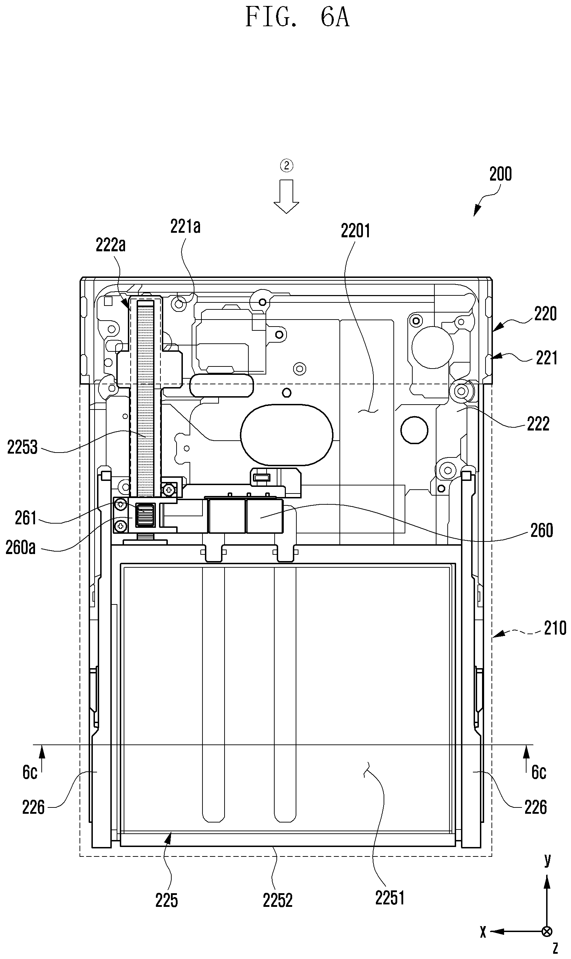

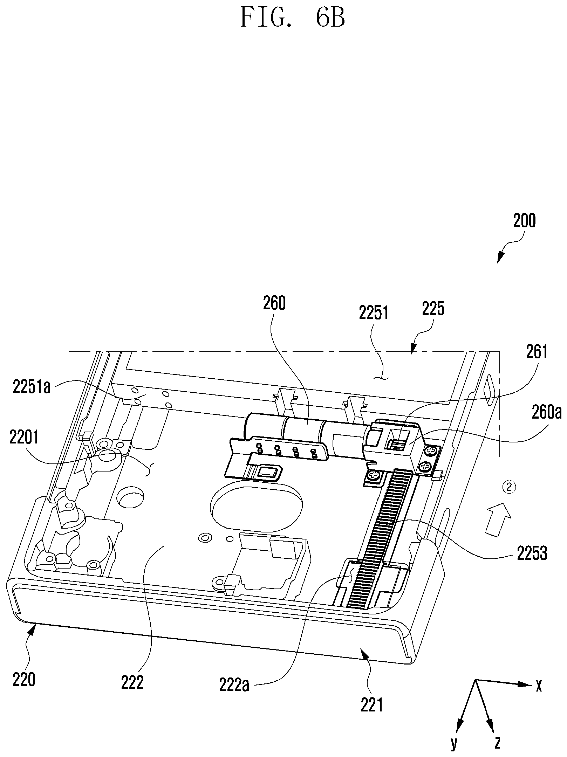

FIG. 6a is a schematic diagram of an electronic device illustrating the disposition structure of a driving motor and a rack in a slide-in state according to various embodiments of the present disclosure. FIG. 6b is a perspective view of a portion of an electronic device illustrating the disposition configuration of a rack accommodated in a second housing in a slide-in state according to various embodiments of the present disclosure.

In describing the electronic device 200 of FIGS. 6a and 6b, components that are substantially the same as those of the electronic device 200 of FIG. 4 are given the same reference numerals, and a detailed description thereof may be omitted.

With reference to FIGS. 6a and 6b, the electronic device 200 may include a first housing 210 having a first space 2101 and a second housing 220 that is slidably coupled to the first housing 210 and has a second space 2201. In one embodiment, the electronic device 200 may include a support bracket 225 fixed to the first housing 210. In one embodiment, the electronic device 200 may include a pair of guide rails 226 fixed to both ends of the support bracket 225. In one embodiment, the second housing 220 may be slidably coupled in a specified direction (e.g., the ±y-axis direction) through the guide rails 226.

According to various embodiments, the electronic device 200 may include a driving motor 260 including a pinion gear 261 disposed in a second space 2201 of the second housing 220. In one embodiment, the electronic device 200 may include a rack 2253 that is fixed to a support bracket 225 disposed in the first space 2101 of the first housing 210 and is disposed in the second space 2201 in a slide-in state. In one embodiment, the rack 2253 may be fixed to a side wall 2251a formed on at least a portion of the support bracket 225 through a screw. In one embodiment, the pinion gear 261 may be gear-coupled to the rack 2253, and by rotating the driving motor 260, the pinion gear 261 may move along the rack 2253, thereby allowing the second housing 220 to slide in a specified direction (e.g., the ±y-axis direction) from the first housing 210. In one embodiment, the driving motor 260 may be disposed to be supported by a motor bracket 260a that is fixed to a second extension member 222 of the second housing 220 through a fastening member, such as a screw. In one embodiment, the motor bracket 260a may guide at least a portion of the rack 2253. For example, the rack 2253 may be guided in a manner of passing between the motor bracket 260a and the second extension member 222.

According to various embodiments, the rack 2253 may be disposed such that, in a slide-in state, the second housing 220 moves in the second direction (direction ② ), such that its end is in contact with or proximate to the upper inner surface 221a of the second space 2201. In one embodiment, the rack 2253 may be moved while being guided by a rack guide 222a provided on the second extension member 222 according to the movement of the second housing 220. In one embodiment, the rack guide 222a may help reduce unintended deformation or movement of the rack 2253 during a sliding motion of the electronic device 200. In one embodiment, the rack guide 222a may include a recess formed lower than a surface of the second extension member 222 in the longitudinal direction (e.g., the ± y-axis direction) along the accommodating trajectory of the rack 2253. For example, at least a portion of the rack 2253 may be accommodated in the recess, thereby reducing left-right movement that may occur during a sliding motion. In some embodiments, the rack guide 222a may be disposed on or formed integrally with the second extension member 222 and may include a guide structure (e.g., a boss) that supports and guides at least the left and right side surfaces of the rack 2253. In some embodiments, the rack guide 222a may be omitted. In one embodiment, the pinion gear 261 and the rack 2253 coupled thereto may be disposed to be biased to one side with respect to the width direction (e.g., the ±x-axis direction) of the electronic device 200, thereby helping secure the size of the substrate assembly 251 (e.g., main substrate) generally disposed in the center of the second space 2201.

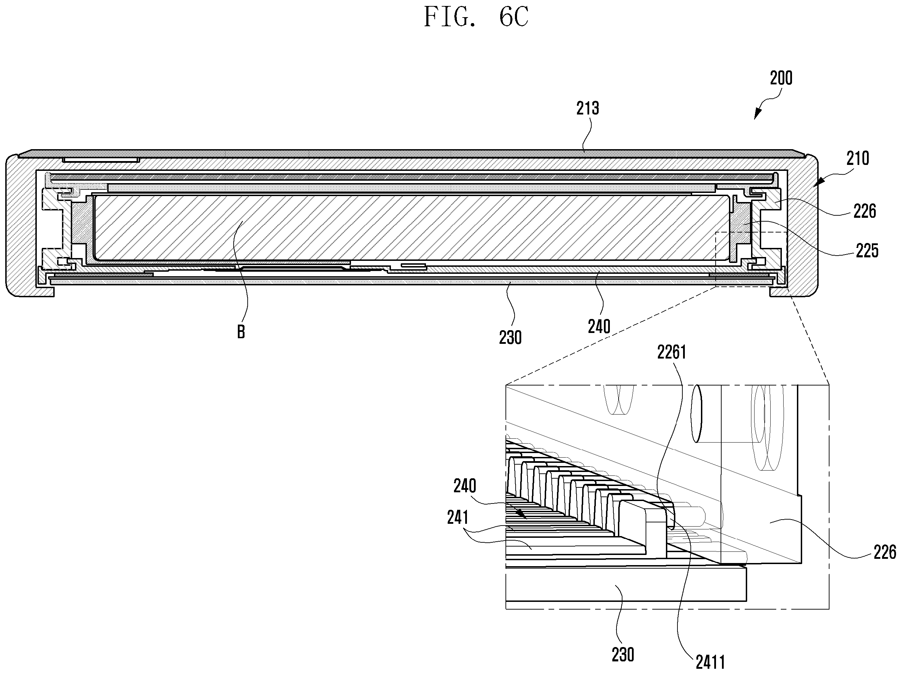

FIG. 6c is a cross-sectional view of an electronic device as viewed along line 6c-6c of FIG. 6a according to various embodiments of the present disclosure.

With reference to FIG. 6c, the electronic device 200 may include a support member 240 for supporting a flexible display 230 and a pair of guide rails 226 for guiding both ends of the support member 240. In one embodiment, the support member 240 may include a plurality of multi-bars 241 that are rotatably coupled to each other and guide protrusions 2411 that are protruded at both ends of each of the multi-bars 241. In one embodiment, the guide rails 226 may be fixed to both sides of a support bracket 225 disposed in a first space 2101 of the first housing 210. In one embodiment, the guide rails 226 may include guide slits 2261 formed at positions corresponding to the movement trajectories of the support member 240. In one embodiment, a guide structure in which a guide protrusion 2411 of a support member 240 fixed in a manner of being at least partially attached to a rear surface of a flexible display 230 moves along a guide slit 2611 formed in a guide rail 226 may help reduce a phenomenon in which the flexible display 230 is detached or deformed during operation.

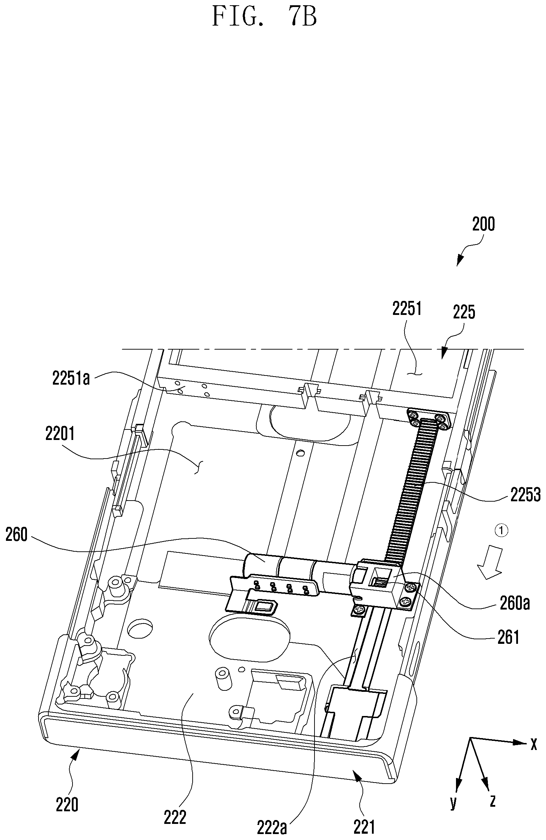

FIG. 7a is a block diagram of an electronic device illustrating the disposition structure of a driving motor and a rack in a slide-out state according to various embodiments of the present disclosure. FIG. 7b is a perspective view of a portion of an electronic device illustrating the disposition configuration of a rack accommodated in a second housing in a slide-out state according to various embodiments of the present disclosure.

In describing the electronic device 200 of FIGS. 7a and 7b, components that are substantially the same as those of the electronic device 200 of FIGS. 6a and 6b are given the same reference numerals, and a detailed description thereof may be omitted.

With reference to FIGS. 7a and 7b, the rack 2253 may be disposed so that its end is away from the upper inner surface 221a of the second space 2201 when the second housing 220 is moved in the first direction (direction ①) in the slide-out state. In one embodiment, at least a portion of the rack 2253 may be disposed to be guided by the rack guide 222a of the second housing 220 in the slide-out state. In one embodiment, at least a portion of the rack 2253 may be disposed to be guided by the rack guide 222a provided in the second housing 220 even when transitioning from the slide-in state to the slide-out state, thereby ensuring operational stability.

According to various embodiments, the sliding distance S (sliding stroke) for the second housing 220 to transition from a slide-in state to a slide-out state may be determined by the length of the rack 2253. In one embodiment, the length of the rack 2253 may be determined by the distance from the support bracket 225 to the upper inner surface 221a of the second space 2201 when the electronic device 200 is in the slide-in state. In one embodiment, the length and/or the sliding distance S of the rack 2253 may be determined by the size of the battery B mounted on the battery mounting portion 2251 of the support bracket 225. In some embodiments, the size of the battery B along the longitudinal direction (e.g., ±y-axis direction) of the electronic device 200 may be determined by the sliding distance S of the second housing 220. For example, when the sliding distance S of the second housing 220 is determined, the size of the battery B is designed to be maximally expandable to correspond to the first space 2201 in response thereto, thereby helping extend the usage time of the electronic device 200. In one embodiment, the battery B and the rack 2253 may have a structure in which they are disposed side by side without overlapping each other when viewing the side surface of the first housing 210 (e.g., the second side surface 2112 or the third side surface 2113 of FIG. 3a) from the outside and when viewing the flexible display 230 from above, so that the battery B is designed to be maximally expandable to a size substantially equal to or similar to the width of the first housing 210 along the width direction (e.g., the ±x-axis direction) of the electronic device 200, thereby helping extend the usage time of the electronic device.

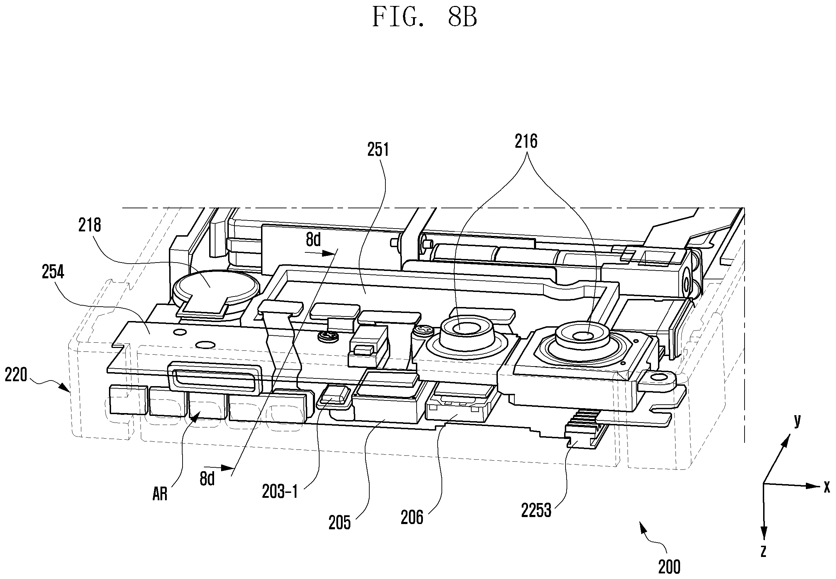

FIG. 8a is a schematic diagram of a portion of an electronic device including electrical components according to various embodiments of the present disclosure. FIG. 8b is a perspective diagram of a portion of an electronic device including electrical components according to various embodiments of the present disclosure.

The electronic device of FIGS. 8a and 8b may be similar to the electronic device of FIGS. 2a to 3b or may further include other embodiments of the electronic device. In one embodiment, FIGS. 8a and 8b are diagrams illustrating the rear surface of the second housing 200 with the second rear surface cover 223 and the window cover 224 removed.

With reference to FIGS. 8a and 8b, the electronic device 200 may include a first housing 210 and a second housing 220 slidably coupled to the first housing. In one embodiment, the second housing 220 may include a second lateral member 221 and a second extension member 222 extending from the second lateral member 221 to a second space 2201. In one embodiment, the second lateral member 221 may include a fourth side surface 2211, a fifth side surface 2212 and a sixth side surface 2213 extending vertically from opposite ends of the fourth side surface 2211, respectively. In one embodiment, the second lateral member 221 and/or the second extension member 222 may be formed of at least partially disposed conductive member (e.g., metal) and a non-conductive member (e.g., polymer) that is injection-molded with the conductive member. In one embodiment, the second lateral member 221 may include conductive portions 310, 311, and 312 segmented by segmentation portions 321, 322, 323, and 324. In one embodiment, the second lateral member 221 may include a first conductive portion 310 segmented through a first segmentation portion 321 and a second segmentation portion 322 disposed at a specified interval on the fourth side surface 2211, a second conductive portion 311 segmented through a third segmentation portion 323 disposed between the first segmentation portion 321 and the fifth side surface 3212, and a third conductive portion 312 segmented through the second segmentation portion 322 and a fourth segmentation portion 324 disposed on the sixth side surface 2213. In one embodiment, at least one of the first conductive portion 310, the second conductive portion 311, or the third conductive portion 312 is electrically connected to a wireless communication circuit of the electronic device 200 (e.g., the wireless communication module 192 of FIG. 1) so as to be used as at least one antenna operating in at least one designated frequency band (e.g., a legacy band).

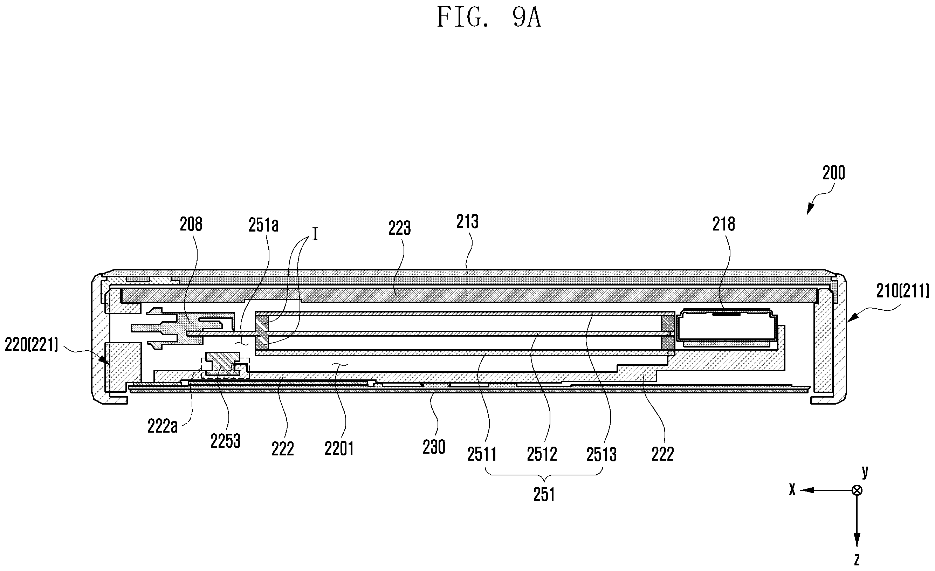

According to various embodiments, the electronic device 200 may include at least one electrical component disposed in the second space 2201 of the second housing 220. In one embodiment, the at least one electrical component may include a substrate assembly 251 (e.g., a main substrate) substantially disposed in a central portion of the second space 2201. In one embodiment, the at least one electrical component may include at least one of a microphone 203-1, a first camera module 205, a second camera module 216, a receiver 206, a speaker 207, a connector port 208, a vibration motor 218 (vibrator), or an array antenna (AR) (e.g., a mmWave antenna module) disposed around the substrate assembly 251. In one embodiment, the substrate assembly 251 is disposed generally centrally in the second space 2201 of the second housing 220, and at least one electrical component is disposed along the periphery thereof, so that efficient electrical connection between the substrate assembly 251 and the at least one electrical component can be possible. In one embodiment, the electronic device 200 may include a second substrate 254 (e.g., a sub-substrate) disposed in the second space 2201. In one embodiment, the second substrate 254 may be disposed in a position that does not overlap with the substrate assembly 251 when viewing the second rear cover (e.g., the second rear surface cover 223 of FIG. 4) from above. In some embodiments, the second substrate 254 may be disposed so as to overlap with at least a portion of the substrate assembly 251. In some embodiments, the second substrate 254 may also be composed of a stacked substrate assembly (e.g., a substrate assembly using an interposer), similar to the substrate assembly 251. In one embodiment, the electronic device 200 may include an antenna substrate 257 (e.g., FRC, flexible RF cable) that at least partially overlaps with the rack 2253 and electrically connects the substrate assembly 251 and the second conductive portion 311 by bypassing the second camera module 216. In one embodiment, at least a portion of the antenna substrate 257 may be disposed in the second space 2201 and supported by at least a portion of a rack guide (e.g., rack guide 222a of FIG. 9a) to which the rack 2253 is guided. In some embodiments, the antenna substrate 257 may be disposed to be supported by a structural change of at least a portion of the second extension member 222.

According to various embodiments, the electronic device 200 may include a rack 2253 secured to the support bracket 225 of the first housing 210 and extended into the second space 2201 of the second housing 220. In one embodiment, the rack 2253 may be disposed to be in contact with or be proximate to the upper inner surface 221a of the second space 2201 when the electronic device 200 is in a slide-in state. Accordingly, the rack 2253 may have an overlapping structure that overlaps with at least one electrical component (e.g., the second camera module 216 and/or the connector port 208) disposed in the second space 2201 when the second rear surface cover 223 is viewed from above. Exemplary embodiments of the present disclosure may provide an efficient stacked structure for reducing the thickness increase of an electronic device 200 because of the overlapping disposition of a rack 2253 and at least one electrical component.

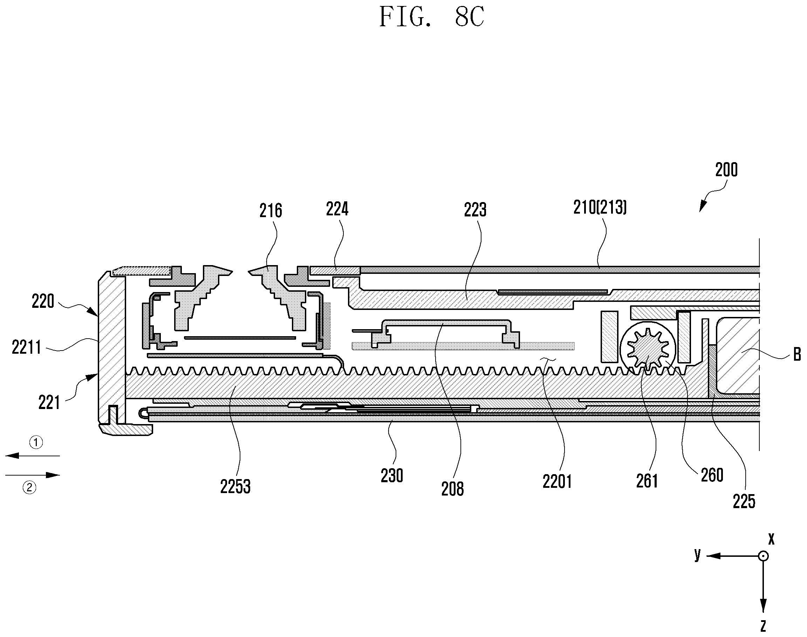

FIG. 8c is a cross-sectional view of a portion of an electronic device taken along line 8c-8c of FIG. 8a according to various embodiments of the present disclosure.

With reference to FIG. 8c, the second camera module 216 of the at least one electrical component may be disposed to overlap with at least a portion of the rack 2253 when the second rear surface cover 223 is viewed from above. In one embodiment, the rack 2253 may be disposed to overlap with the second camera module 216 in a slide-in state. In one embodiment, the second camera module 216 may be disposed to detect an external environment through the second rear surface cover 223. Accordingly, the rack 2253 may be disposed between the second camera module 216 and the second extension member 222 of the second lateral member 221 (or the flexible display 230) in the second space 2201. For example, the rack 2253 may be disposed in a dead space between the second camera module 216 and the flexible display 230 (or the second extension member 222 at a position that is biased to one side of the electronic device 200, thereby helping improve the disposition efficiency of the electrical components (e.g., improving the design freedom of the substrate assembly and/or the second substrate). In one embodiment, some of the electrical components among the at least one electrical component may be disposed to avoid overlapping with the rack 2253 when the second rear surface cover 223 is viewed from above. In one embodiment, the microphone 203-1, the first camera module 205, the receiver 206, the speaker 207, or the array antenna (AR) may be disposed in the second space 2201 so as not to overlap with the rack 2253.

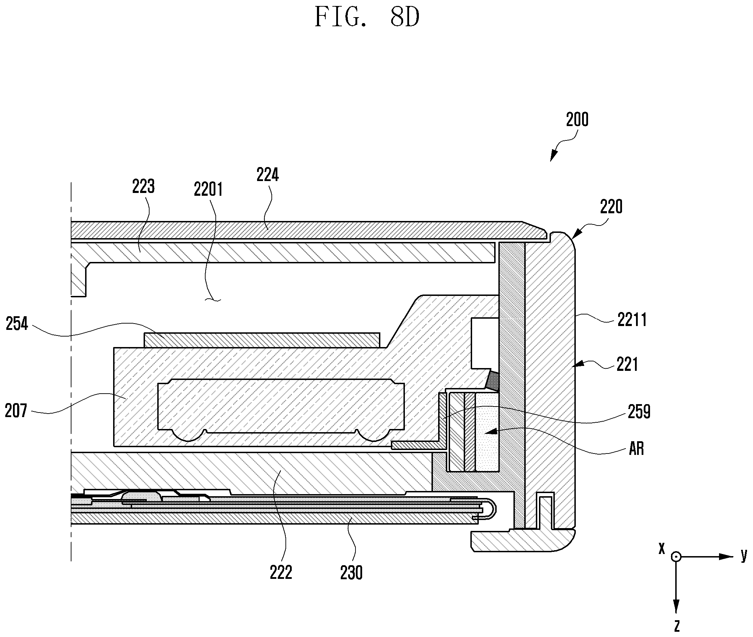

FIG. 8d is a cross-sectional view of a portion of an electronic device taken along line 8d-8d of FIG. 8b according to various embodiments of the present disclosure.

With reference to FIGS. 8a and 8d, the electronic device 200 may include an array antenna (AR) (e.g., a mmWave module) disposed in a second space 2201 of a second housing 220. In one embodiment, the array antenna (AR) may be disposed to be biased to one side of the upper inner surface 221a in consideration of the disposition of the rack 2253. In one embodiment, the array antenna (AR) may include a substrate and a plurality of antenna elements disposed at a specified interval on the substrate, and the plurality of antenna elements may be configured to generally form a directional beam in a direction (e.g., the y-axis direction) toward the fourth side surface 2211 by being electrically connected to a wireless communication circuit (e.g., the wireless communication module 192 of FIG. 1). In one embodiment, the array antenna (AR), as a mmWave module, may be configured to transmit or receive wireless signals in the range of about 3 GHz to 100 GHz.

According to various embodiments, the electronic device 200 may include a heat dissipation structure for dissipating heat generated from the array antenna (AR) to the surroundings. In one embodiment, the electronic device 200 may include a heat transfer member 259 disposed so that one end is proximate to or is in contact with the array antenna (AR) and the other end is proximate to or is in contact with the second extension member 222 and/or the speaker 207. In one embodiment, the heat transfer member 259 and/or the second rear surface cover 223 may be formed of a metal material that is advantageous for heat diffusion.

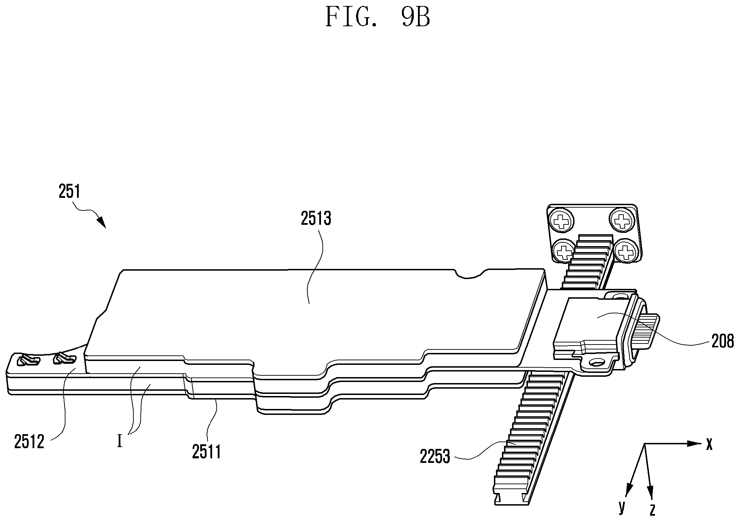

FIG. 9a is a cross-sectional view of an electronic device taken along line 9a-9a of FIG. 8a according to various embodiments of the present disclosure. FIG. 9b is a perspective view illustrating a disposition structure of a substrate assembly and a connector port according to various embodiments of the present disclosure.

With reference to FIGS. 9a and 9b, the substrate assembly 251 may be disposed in a manner that a plurality of printed circuit boards (PCBs) 2511, 2512, and 2513 are stacked through an interposer I in the second space 2201. In one embodiment, the substrate assembly 251 may include a first printed circuit board 2511, a second printed circuit board 2512, and a third printed circuit board 2513 that are sequentially stacked from the second extension member 222 in a direction (e.g., the -z-axis direction) toward the second rear surface cover 223. In one embodiment, each of the printed circuit boards 2511, 2512, and 2513 may be electrically connected to each other through the interposer I. In one embodiment, each of the printed circuit boards 2511, 2512, and 2513 may be disposed to at least partially overlap with the second rear surface cover 223 when viewed from above.

According to various embodiments, at least one printed circuit board of the substrate assembly 251 may be disposed to overlap with the rack 2253 when the second rear surface cover 223 is viewed from above. For example, at least a portion of the second printed circuit board 2512 disposed at a position having a height (e.g., a height from the second extension member) so as not to interfere with the disposition of the rack 2253 may protrude outwardly relative to the other printed circuit boards 2511 and 2513, thereby overlapping with the rack 2253. In some embodiments, the third printed circuit board 2513 may also be disposed to overlap with at least a portion of the rack 2253 when the second rear surface cover 223 is viewed from above. Accordingly, a space below the protruding portion of the second printed circuit board 2512 may be provided as a rack accommodation space 251a for accommodating the rack 2253. In some embodiments, the second printed circuit board 2512 may be formed to have the same size as the first printed circuit board 2511 but may be disposed to be pushed to one side with respect to the first printed circuit board 2511, thereby helping provide a rack accommodation space 251a. In one embodiment, the protruding portion of the second printed circuit board 2512 may be used for disposing at least one electrical component. For example, the connector port 208 may be disposed in that portion, thereby helping center-align the connector port 208 in the second space 2201.

According to an exemplary embodiment of the present disclosure, the rack 2253 may be accommodated in a rack accommodation space 251a provided in the substrate assembly 251, thereby helping slim down (e.g., reduce thickness) the electronic device 200 and improve the efficiency of disposition with peripheral electrical components.

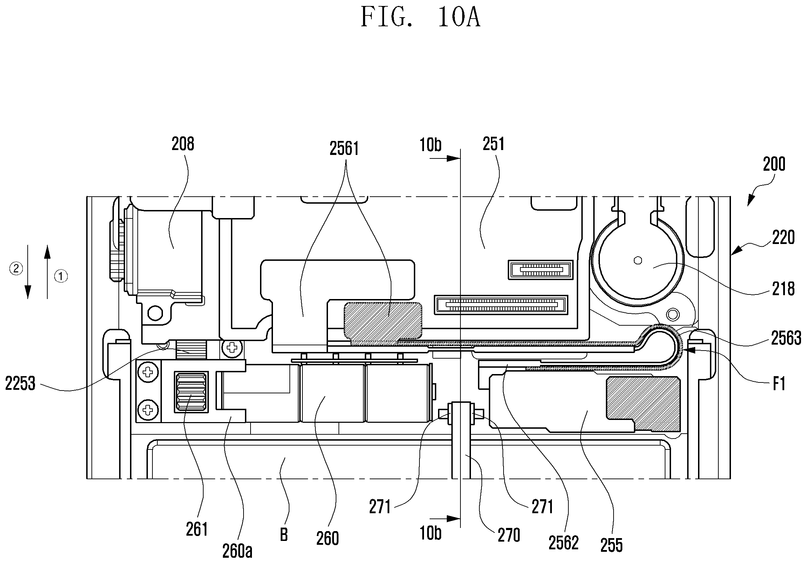

FIG. 10a is a block diagram of a portion of an electronic device according to various embodiments of the present disclosure.

With reference to FIG. 10a, the electronic device 200 may include a flexible substrate F1 for electrically connecting a substrate assembly 251 disposed in a second space 2201 of a second housing 220 and a third substrate 255 (e.g., a small PCB) disposed in a first space 2101 of a first housing 210. In one embodiment, the third substrate 255 may be fixed in the first space 2101 through a support bracket 225 and may be electrically connected to the first substrate 252 and/or the antenna member 253 disposed in the first housing 210. Accordingly, the first substrate 252 and the antenna member 253 may be electrically connected to the substrate assembly 251 through the third substrate 255 and the flexible substrate F1. In one embodiment, the third substrate 255 may be disposed around the driving motor 260 and may include a charging IC for the battery B and/or a control circuit for the driving motor.

According to various embodiments, the flexible substrate F1 may be disposed to have a length or shape that can accommodate the sliding distance of the electronic device 200. In one embodiment, the flexible substrate F1 may be formed of an elastic material or shape that expands in a slide-out state and returns to its original position in a slide-in state. In one embodiment, the flexible substrate F1 may include a first connector portion 2561 for electrically connecting to the substrate assembly 251, a second connector portion 2562 for electrically connecting to the third substrate 255, and a connecting portion 2563 that connects the first connector portion 2561 and the second connector portion 2562 and is formed so that its shape can be restored to its original state from an extended state. In one embodiment, the connecting portion 2563 may be shaped to bend at least once in different directions to provide a length to accommodate the sliding distance, even in a relatively small space. In one embodiment, the flexible substrate F1 may include a flexible printed circuit board (FPCB) or a flexible RF cable (FRC).

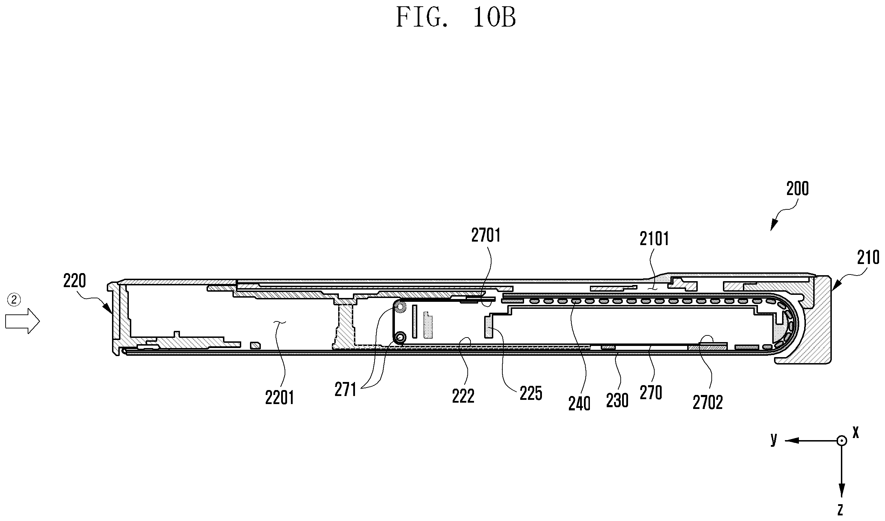

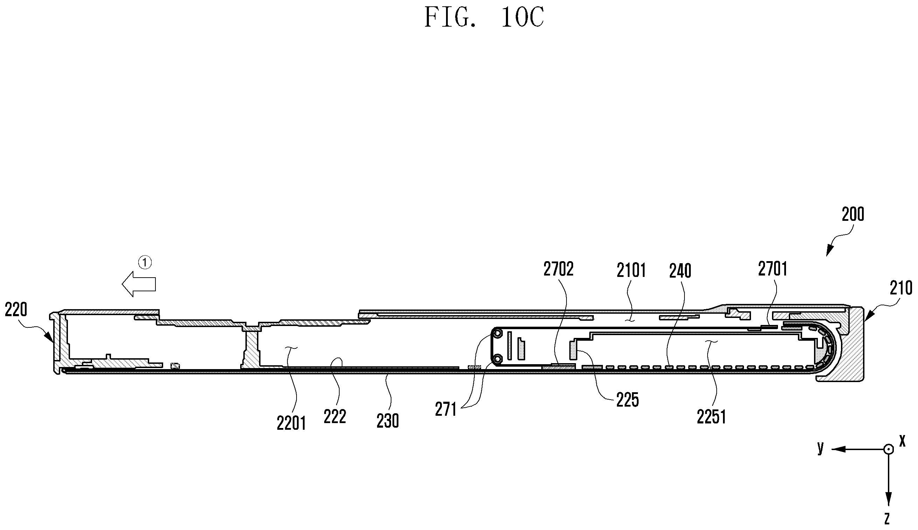

FIG. 10b is a cross-sectional view of an electronic device taken along line 10b-10b of FIG. 10a according to various embodiments of the present disclosure. FIG. 10c is a cross-sectional view illustrating a slide-out state of the electronic device of FIG. 10a according to various embodiments of the present disclosure. With reference to FIGS. 10b and 10c, the electronic device 200 may include at least one driving belt 270 (e.g., a life belt or a tension belt) to support the flexible display 230 and reduce lifting of the flexible display 230 by providing uniform tension during operation. In one embodiment, the driving belt 270 may help reduce driving resistance because of eccentricity of the second housing 220 moved by driving the driving motor 260. In one embodiment, at least one driving belt 270 may be disposed to be generally biased to the left of the electronic device 200 (e.g., the rack 2253 of FIG. 10a) and symmetrically disposed to the right with respect to the center, thereby assisting in the smooth operation of the flexible display 230 in a balanced manner. In one embodiment, one end 2701 of the driving belt 270 may be fixed to an end of the support member 240, and the other end 2702 may be fixed to at least a portion of the second extension member 222 of the second housing 220. In one embodiment, the driving belt 270 may be disposed in a manner such that it is wound around at least one rotary roller 271 rotatably disposed on the support bracket 2250. In one embodiment, when the second housing 220 transitions from a slide-in state to a slide-out state, one end 2701 of the driving belt 270 may move along the support member 240 in a first spatial direction (e.g., the -y-axis direction), and the other end 2702 of the driving belt 270 may move along the second housing 220 by a corresponding amount of movement in a second spatial direction (e.g., the y-axis direction). For example, the driving belt 270 may move while being supported by at least one rotary roller 271 and the support member 2252 of the support bracket 225, but the distance from one end 2701 fixed to the support member 240 to the other end 2702 fixed to the second housing 220 may not change. Accordingly, the driving belt 270 may help the flexible display 230 to always remain tight even during a sliding motion.

FIG. 11 is a block diagram of an electronic device illustrating the disposition structure of an antenna member and a first substrate according to various embodiments of the present disclosure.

With reference to FIG. 11, the electronic device 200 may include a first substrate 252 and an antenna member 253 disposed in a space between a first extension member 212 and a first rear surface cover 213. In one embodiment, the antenna member 253 may include a coil member disposed through a dielectric film. In one embodiment, the antenna member 253 may include a multi-function coil or multi-function core (MFC) antenna for performing a wireless charging function, a near field communication (NFC) function, and/or an electronic payment function. In one embodiment, the first substrate 252 may be disposed in such a way that a connector portion 252a extended from the first substrate 252 passes through a first through-hole 210a formed in the first extension member 212 and is then electrically connected to a flexible substrate (e.g., the flexible substrate F1 of FIG. 11a) disposed in the first space 2101. In one embodiment, the antenna member 253 may also be disposed in such a way that a connector portion 253a extended from the antenna member 253 passes through a first through-hole 210a and is then electrically connected to a flexible substrate F1 disposed in the first space 2101. In some embodiments, the first substrate 251 and the antenna member 253 may be disposed to be electrically connected to the flexible substrate F1 in the first space 2101 after each of the first substrate 251 and the antenna member 253 passes through different through holes disposed in the first extension member 212.

According to various embodiments, the electronic device 200 may include a microphone 203 as an input device that extends from the first substrate 251 and is disposed through a second through-hole 210b formed in the second side surface 2112 of the first housing 210. In one embodiment, the first housing 210 may include a third through-hole 210c disposed in the second side surface 2112 and/or the third side surface 2113. The third through-hole 210c may be formed in a manner that connects the first space 2101 from the outside, and thus may be used as a fastening path for fastening a guide rail (e.g., the guide rail 226 of FIG. 4) to a support bracket (e.g., the support bracket 225 of FIG. 4) through a fastening member such as a screw through the third through-hole 210c.

According to various embodiments, an electronic device (e.g., the electronic device 200 of FIG. 4a) may comprise: a first housing (e.g., the first housing 210 of FIG. 4a); a second housing (e.g., the second housing 220 of FIG. 4a) slidably coupled to the first housing; a flexible display (e.g., the flexible display 230 of FIG. 4a) having a display area that is variable on the basis of the slide-in or slide-out of the second housing; a driving motor (e.g., the driving motor 260 of FIG. 4a) disposed in the second housing and including a pinion gear (e.g., the pinion gear 261 of FIG. 4a); a rack (e.g., the rack 2253 of FIG. 4a) fixedly coupled to the first housing and including a rack gear driven by being gear-coupled to the pinion gear; and a rack guide (e.g., the rack guide 222a of FIG. 6a) disposed in the second housing and protecting the rack from external impact, wherein the rack guide may be disposed on the left side of the driving motor and spatially overlap with a camera module, and while the pinion gear and the rack gear are being driven by being gear-coupled to each other, the second housing may be configured to be driven to slide-in or slide-out on the basis of the reciprocating movement of the rack into the rack guide.

According to various embodiments, a multi-bar (e.g., the multi-bar 240 of FIG. 4a) supporting the rear surface of a portion of the flexible display and a driving belt (e.g., the driving belt 270 of FIG. 10a) connected to one end of the multi-bar and one end of the second housing may be disposed.

According to various embodiments, the driving belt may be disposed to be located in a central portion of the electronic device.

According to various embodiments, the electronic device may include a substrate assembly disposed in the second housing, and the substrate assembly may include a first printed circuit board (PCB) (e.g., the first printed circuit board 2511 of FIG. 9a), a second printed circuit board (e.g., the second printed circuit board 2512 of FIG. 9a) stacked on the first printed circuit board, and an interposer I disposed therebetween to electrically connect the first printed circuit board and the second printed circuit board, wherein when the flexible display is viewed from above, the first printed circuit board and the second printed circuit board may be disposed to at least partially overlap.

According to various embodiments, the second printed circuit board may be disposed to include a portion that partially protrudes laterally from the first printed circuit board when the flexible display is viewed from above, and the rack may be disposed in a space overlapping with the protruding portion (e.g., the rack accommodation space 251a of FIG. 9a).

According to various embodiments, the rack may be disposed to overlap with at least a portion of the camera module when the flexible display is viewed from above in the slide-in state.

According to various embodiments, the camera module may be disposed between the rack and the rear surface of the electronic device in the second housing.

According to various embodiments, the camera module may be disposed in the second housing to detect an external environment through a rear surface of the second housing.

According to various embodiments, the electronic device may include at least one electrical component disposed in the second housing, wherein the at least one electrical component may include at least one of a substrate assembly (e.g., the substrate assembly 251 of FIG. 8a) disposed substantially centrally, at least one microphone (e.g., the microphone 203-1 of FIG. 8a) disposed to surround the substrate assembly, at least one camera module (e.g., the first camera module 205 and the second camera module 216 of FIG. 8a), and one of a receiver (e.g., the receiver 206 of FIG. 8a), a speaker (e.g., the speaker 207 of FIG. 8a), a connector port (e.g., the connector port 208 of FIG. 8a), a vibration motor (e.g., the vibration motor 218 of FIG. 8a), or an antenna module (e.g., the array antenna (AR) of FIG. 9a).

According to various embodiments, in the first housing, a battery (e.g., the battery B of FIG. 4a) is disposed parallel to the rack, and when a side surface of the first housing (e.g., the second side surface 2112 or the third side surface 2113 of FIG. 4a) is viewed from the outside in a direction perpendicular to the sliding direction, the rack and the battery may be disposed so as not to overlap each other.

According to various embodiments, when viewing the flexible display from above, the rack and the battery may be disposed so as not to overlap.

According to various embodiments, the sliding distance of the second housing (e.g., the sliding distance S of FIG. 7a) may be determined through the length of the rack.

According to various embodiments, the length of the rack may be determined as the distance from the fixed portion of the rack to the upper inner surface of the second housing (e.g., the inner surface 221a of FIG. 5a) in the slide- in state.

According to various embodiments, the rack may be disposed so as to be proximate to or be in contact with an upper inner surface of the second housing in the slide-in state.

According to various embodiments, the size of the battery may be determined by the length of the rack.

According to various embodiments, the rack may be disposed so as to be at least partially disposed within the second housing in the slide-out state.

According to various embodiments, an electronic device (e.g., the electronic device 200 of FIG. 4a) may comprise: a first housing (e.g., the first housing 210 of FIG. 4a); a second housing (e.g., the second housing 220 of FIG. 4a) slidably coupled to the first housing; a flexible display (e.g., the flexible display 230 of FIG. 4a) having a display area that is variable on the basis of the slide-in or slide-out of the second housing; a driving motor (e.g., the driving motor 260 of FIG. 4a) disposed in the second housing and including a pinion gear (e.g., the pinion gear 261 of FIG. 4a); a rack (e.g., the rack 2253 of FIG. 4a) fixedly coupled to the first housing and including a rack gear driven by being gear-coupled to the pinion gear; and a battery (e.g., the battery B of FIG. 4a) disposed parallel to the rack, wherein when a side surface of the first housing (e.g., the second side surface 2112 or the third side surface 2113 of FIG. 4a) is viewed from the outside in a direction perpendicular to the sliding direction, the rack and the battery may be disposed so as not to overlap each other.

According to various embodiments, when viewing the flexible display from above, the rack and the battery may be disposed so as not to overlap.

According to various embodiments, the rack may be disposed so as to be proximate to or be in contact with an upper inner surface of the second housing in the slide-in state.

According to various embodiments, the size of the battery may be determined by the length of the rack.

And the embodiments of the present disclosure disclosed in this specification and drawings are only specific examples presented to easily explain the technical contents according to the embodiments of the present disclosure and to help understand the embodiments of the present disclosure, and are not intended to limit the scope of the embodiments of the present disclosure. Therefore, the scope of the various embodiments of the present disclosure should be interpreted as including all changes or modified forms derived on the basis of the technical ideas of the various embodiments of the present disclosure in addition to the embodiments disclosed herein.

## Claims

1. An electronic device 200 comprising:
a first housing 210;
a second housing 220 slidably coupled to the first housing;
a flexible display 230 having a display area that is variable on the basis of the slide-in or slide-out of the second housing;
a driving motor 260 disposed in the second housing and including a pinion gear 261;
a rack 2253 fixedly coupled to the first housing and including a rack gear driven by being gear-coupled to the pinion gear; and
a rack guide disposed in the second housing and protecting the rack from external impact, wherein
the rack guide may be disposed on the left side of the driving motor and spatially overlap with the camera module, and,
while the pinion gear and the rack gear are being driven by being gear-coupled to each other, the second housing may be configured to be driven to slide-in or slide-out on the basis of the reciprocating movement of the rack into the rack guide.

2. The electronic device of claim 1, wherein
a multi-bar 240 supporting the rear surface of a portion of the flexible display and a driving belt 270 connected to one end of the multi-bar and one end of the second housing are disposed.

3. The electronic device of claim 1, wherein
the driving belt is disposed to be located at the central portion of the electronic device.

4. The electronic device of claim 1, comprising a substrate assembly 251 disposed in the second housing, wherein
the substrate assembly comprises:
a first printed circuit board (PCB) 2511;
a second printed circuit board (PCB) 2512 stacked on the first printed circuit board; and
an interposer I disposed between the first printed circuit board and the second printed circuit board to electrically connect them, and
the first printed circuit board and the second printed circuit board are disposed to at least partially overlap each other when the flexible display is viewed from above.

5. The electronic device of claim 4, wherein
the second printed circuit board is disposed so as to include a portion that partially protrudes laterally from the first printed circuit board when the flexible display is viewed from above, and
the rack is disposed in a space 251a overlapping with the protruding portion.

6. The electronic device of claim 1, wherein
the rack overlaps with at least a portion of the camera module when the flexible display is viewed from above in the slide-in state.

7. The electronic device of claim 6, wherein
the camera module is disposed between the rack and the rear surface of the electronic device in the second housing.

8. The electronic device of claim 6, wherein
the camera module is disposed to detect the external environment through the rear surface of the second housing in the second housing.

9. The electronic device of one of claims 1 to 8 comprising at least one electrical component disposed in the second housing, wherein
the at least one electrical component comprises at least one of a substrate assembly 251 substantially centrally disposed, at least one microphone 203-1 disposed to surround the substrate assembly, at least one camera module 205 and 216, a receiver 206, a speaker 207, a connector port 208, a vibration motor 218, or an antenna module (AR).

10. The electronic device of one of claims 1 to 9 comprising a battery B disposed parallel to the rack in the first housing, wherein
the rack and the battery are disposed so as not to overlap each other when viewing the side surface 2112 and 2113 of the first housing from the outside in a direction perpendicular to the sliding direction.

11. The electronic device of claim 10, wherein
the rack and the battery are disposed so as not to overlap when the flexible display is viewed from above.

12. The electronic device of claim 10, wherein
the sliding distance S of the second housing is determined through the length of the rack.

13. The electronic device of claim 10, wherein
the length of the rack is determined as the distance from the fixed portion of the rack to the upper inner surface 221a of the second housing in the slide-in state.

14. The electronic device of claim 10, wherein
the rack is disposed so as to be proximate to or be in contact with the upper inner surface of the second housing in the slide-in state.

15. The electronic device of claim 10, wherein
the size of the battery is determined by the length of the rack.
